(19) Europäisches Patentamt
European Patent Office
Office européen des brevets

(11) **EP 2 027 656 B1**

(12) **EUROPÄISCHE PATENTSCHRIFT**

(45) Veröffentlichungstag und Bekanntmachung des Hinweises auf die Patenterteilung:
**30.09.2020   Patentblatt 2020/40**

(21) Anmeldenummer: **07725860.6**

(22) Anmeldetag: **05.06.2007**

(51) Int Cl.:
**H03M 13/27** *(2006.01)*      **H04L 1/00** *(2006.01)*

(86) Internationale Anmeldenummer:
**PCT/EP2007/004998**

(87) Internationale Veröffentlichungsnummer:
**WO 2007/140998 (13.12.2007 Gazette 2007/50)**

(54) **SENDER MIT EINER NTERLEAVER-VORRICHTUNG UND EMPFÄNGER FÜR EIN VON DEM SENDER ERZEUGTES SIGNAL**

TRANSMITTER APPARATUS WITH INTERLEAVER MEANS AND RECEIVER FOR A SIGNAL PRODUCED BY THE TRANSMITTER APPARATUS

ÉMITTEUR AVEC DISPOSITIF D'ENTRELACEMENT ET RÉCEPTEUR POUR UN SIGNAL GÉNÉRÉ PAR LE ÉMITTEUR

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **09.06.2006   DE 102006026895**

(43) Veröffentlichungstag der Anmeldung:
**25.02.2009   Patentblatt 2009/09**

(60) Teilanmeldung:
**20192403.2**

(73) Patentinhaber: **Fraunhofer-Gesellschaft zur Förderung der angewandten Forschung e.V.
80686 München (DE)**

(72) Erfinder:
• **EBERLEIN, Ernst**
  **91091 Erlangen (DE)**
• **BREILING, Marco**
  **91052 Erlangen (DE)**
• **KEIP, Cedric**
  **91054 Erlangen (DE)**
• **STADALI, Holger**
  **91058 Erlangen (DE)**
• **HEUBERGER, Albert**
  **91056 Erlangen (DE)**

(74) Vertreter: **Zinkler, Franz et al
Schoppe, Zimmermann, Stöckeler
Zinkler, Schenk & Partner mbB
Patentanwälte
Radlkoferstrasse 2
81373 München (DE)**

(56) Entgegenhaltungen:
**EP-A- 0 844 741      EP-A2- 0 844 741
US-A- 5 968 200**

• **HEEGARD C ET AL: "TURBO CODING" TURBO CODING, KLUWER INTERNATIONAL SERIES IN ENGINEERING AND COMPUTER SCIENCE, BOSTON, MA : KLUWER ACADEMIC PUBL, US, 1999, Seiten 35-63, XP002256962 ISBN: 0-7923-8378-8**
• **SHARMA N ET AL: "Soft decision multi-user iterative decoding using a block turbo code for SFH/SSMA" PERSONAL, INDOOR AND MOBILE RADIO COMMUNICATIONS, 2000. PIMRC 2000. THE 11TH IEEE INTERNATIONAL SYMPOSIUM ON SEPT. 18-21, 2000, PISCATAWAY, NJ, USA,IEEE, Bd. 1, 18. September 2000 (2000-09-18), Seiten 736-740, XP010520731 ISBN: 0-7803-6463-5**

- F. BELLONI: "Fading models" S-72.333 POSTGRADUATE COURSE IN RADIO COMMUNICATIONS AUTUMN 2004, [Online] 2004, Seiten 1-4, XP002467198 Gefunden im Internet: URL:http://www.comlab.hut.fi/opetus/333/2004_2005_slides/Fading_models_text.pdf> [gefunden am 2008-02-01]
- HEEGARD C ET AL: "TURBO CODING", 1 January 1999 (1999-01-01), TURBO CODING; [KLUWER INTERNATIONAL SERIES IN ENGINEERING AND COMPUTER SCIENCE], BOSTON, MA : KLUWER ACADEMIC PUBL, US, PAGE(S) 35 - 63, XP002256962, ISBN: 978-0-7923-8378-9
- SHARMA N ET AL: "Soft decision multi-user iterative decoding using a block turbo code for SFH/SSMA", PERSONAL, INDOOR AND MOBILE RADIO COMMUNICATIONS, 2000. PIMRC 2000. TH E 11TH IEEE INTERNATIONAL SYMPOSIUM ON SEPT. 18-21, 2000, PISCATAWAY, NJ, USA,IEEE, vol. 1, 18 September 2000 (2000-09-18), pages 736-740, XP010520731, ISBN: 978-0-7803-6463-9

- BELLONI F: "Fading models", INTERNET CITATION, 1 January 2004 (2004-01-01), XP002467198, Retrieved from the Internet: URL:http://www.comlab.hut.fi/opetus/333/2004_2005_slides/Fading_models_text.pdf [retrieved on 2008-02-01]

**Beschreibung**

Die vorliegende Erfindung bezieht sich auf die digitale Übertragungstechnik und insbesondere auf Übertragungskonzepte, die besonders gut für zeitlich veränderliche Übertragungskanäle, wie sie im Mobilfunk und Rundfunk anzutreffen sind, geeignet sind.

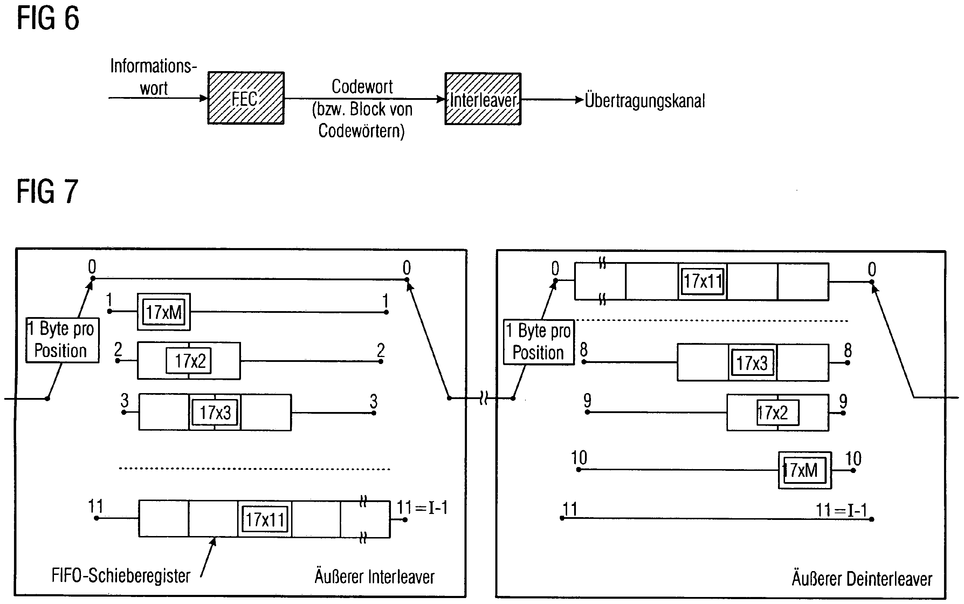

Zeitinterleaving und/oder Frequenzinterleaving kombiniert mit Fehler korrigierenden Codes (Forward Error Correction, FEC) gehört zu einem Grundprinzip in der Übertragungstechnik, wie es in Fig. 6 gezeigt ist.

Ein Informationswort bestehend aus Informationsbits wird hierbei in einen FEC-Encoder gegeben, der aus diesem Informationswort ein Codewort erstellt, d.h. einen Vektor aus Codesymbolen oder Codebits. Diese Codewörter bzw. daraus gebildete Blöcke werden zum Interleaver gegeben. Dieser verändert die Reihenfolge der Symbole und gibt die so gemischten Symbole an den Übertragungskanal. Die Umsortierung der Symbole kann in der Zeitachse erfolgen ("Zeitinterleaving") und/oder in der Frequenzachse ("Frequenzinterleaving").

Die Verwendung eines Interleavers ist dann sinnvoll, wenn der Übertragungskanal nicht statisch ist, d.h. wenn sich seine Eigenschaften über der Zeit bzw. der Frequenz ändern. So kann die im Empfänger ankommende Signalleistung bei einem bewegten Empfänger stark variieren. Dadurch sind manche Codesymbole mit einer größeren Wahrscheinlichkeit fehlerhaft (z.B. durch überlagertes thermisches Rauschen) als andere.

Je nach Bewegung von Sender, Empfänger bzw. Objekten längs des Übertragungsweges und je nach Beschaffenheit der Umgebung von Sender, Empfänger und Übertragungsweg können sich die Kanaleigenschaften mehr oder weniger schnell ändern. Ein Maß für die zeitliche Konstanz des Übertragungskanals ist die Kohärenzzeit: in dieser Zeit ändert sich der Kanal nicht signifikant.

Die Wahrscheinlichkeit eines Übertragungsfehlers wird in der Regel aus dem Kanalzustand (engl. Channel state) abgeschätzt. Der Kanalzustand beschreibt die Qualität des Empfangssignals (z.B. das momentane Verhältnis von Signalstärke zu Rauschen). Ziel eines Interleavers ist es, die Information in der Zeit (und oft auch in der Frequenz) so zu verteilen, dass bei zeitveränderlichen Kanaleigenschaften nach dem Deinterleaver, der den Interleaver auf Sendeseite rückgängig macht, das Verhältnis "gute" (geringe Wahrscheinlichkeit eines Übertragungsfehlers) zu "schlechten" Symbole (hohe Wahrscheinlichkeit eines Übertragungsfehlers) im Mittel annähernd zeitlich konstant wird. Bei sich schnell ändernden Kanaleigenschaften (z.B. hohen Fahrzeuggeschwindigkeiten) reicht also in der Regel ein relativ kurzer Interleaver aus. Bei langsam zeitveränderlichen Kanaleigenschaften sollte eine entsprechend größere Interleaverlänge gewählt werden.

Die Änderung der Kanaleigenschaften kann von verschiedenen Effekten resultieren

- Im Falle von Mehrwegausbreitung bestimmt die relative Phasenlage der Signalanteile, ob sich die Signalanteile konstruktiv oder destruktiv überlagern. Schon eine Änderung der Position um einen Bruchteil der Wellenlänge des Trägersignals führt hier zu anderen Phasenlagen. Entsprechend schnell können sich die Kanaleigenschaften ändern. Man spricht hier von "schnellem Fading" (engl. fast fading).
- Die Signaleigenschaften hängen aber auch stark von der Umgebung ab. So dämpfen z.B. Wände das Signal. Entsprechend ist in der Regel die Signalqualität innerhalb eines Hauses schlechter als außerhalb. Die mit der Umgebung korrelierte Änderung der Signaleigenschaften ändert sich im Vergleich zum schnellen Fading langsam. Entsprechend spricht man hier von "langsamem Fading".

In der Regel werden beim Interleaver-Design nur die Eigenschaften des schnellen Fadings berücksichtigt. Da aber die Speicherkosten immer geringer werden, werden nun auch zunehmend sehr lange Interleaver interessant. In diesem Fall müssen die Eigenschaften des langsamen Fadings zunehmend beim Interleaver-Design berücksichtigt werden.

Als Beispiele für langsames Fading können genannt werden:

- Mobilempfang von Satellitensignalen. Für ein fahrendes Auto ändert sich das Empfangsszenario entsprechend der Umgebung ständig. Für jedes Empfangsszenario können drei Empfangszustände definiert werden:

  ○ Es besteht Sichtverbindung zum Satelliten (z.B. offene Straße). Man spricht dann vom "Line-of-Sight state" (LOS)
  ○ Die Signale sind gedämpft (z.B. durch Bäume). Diesen Zustand bezeichnet man oft als "Shadow state"
  ○ Das Signal ist so stark gedämpft, dass es nicht mehr nutzbar ist. Man spricht dann häufig vom "Blockage state".

- Übertragung in zellularen Netzwerken mit Sendern relativ geringer Sendeleistung.
  In zellularen Netzwerken wird eine Flächendeckung durch viele Sender erreicht. Für diese Art von Netzwerken muss damit gerechnet werden, dass sich die Empfangsbedingungen relativ schnell ändern. Da der Senderabstand gering ist, kann sich der relative Abstand des Empfängers schnell ändern. In diesem Fall können sich die Signaleigenschaften bei langen Interleavern bereits innerhalb der Interleaverlänge stark ändern.

Im Empfänger wird die im Sender durchgeführte Vertauschung von Codesymbolen (=Interleaving) wieder rückgängig gemacht (=Deinterleaving). Das führt dazu, dass bei der Übertragung auftretende Burstfehler nach dem Deinterleaver als Einzelfehler auf den ganzen Datenblock verteilt werden und damit leichter vom FEC-Decoder korrigiert werden können.

Folgende Interleavertypen sind zu unterscheiden:

- Faltungs-Interleaver
- Block-Interleaver

Bei Faltungs-Interleavern handelt es sich um ein "Inter-Block-Interleaving", d.h. die Blöcke werden in der Zeit derart "verschmiert", dass Blöcke, die vor dem Interleaver aufeinander folgen, hinter dem Interleaver ineinander verwoben sind. Hierbei setzt sich ein Block aus einem oder mehreren Codewörtern zusammen. Die Interleaverlänge hängt nicht von der Blockgröße, sondern von der Breite des Verschmierens ab.

Bei einem beispielhaften Faltungs-Interleaver wird ein Block von FEC-Codesymbolen durch den Interleaver auf z.B. vier ungleich große Teilblöcke aufgeteilt und mit den davor - bzw. dahinter liegenden Blöcken verwoben.

Faltungs-Interleaver sind gekennzeichnet durch

- Der Ausgang des FEC Encoders wird über einen De-plexer in verschiedene Teildatenströme unterteilt. Das Prinzip ist in Fig. 7 dargestellt. Der Datenstrom wird dabei in der Regel bitweise oder in Gruppen von bits ("Symbole") auf die Teildatenströme verteilt. Jeder Teildatenstrom wird dann über Verzögerungsleitungen (z.B. implementiert über FIFOs) verzögert.

- Zur Synchronisation des Faltungs-De-Interleavers im Receiver muss lediglich der De-Multiplexer synchronisiert werden.

- Die Länge der Verzögerungsleitungen kann regelmäßig abgestuft sein. Es können aber auch beliebige Anordnungen gewählt werden, so dass aufeinander folgende Symbole möglichst weit auseinander liegen und damit die Kanaleigenschaften unkorreliert sind.

Bei Blockinterleavern findet ein "Intra-Block-Interleaving" statt, d.h. die Verarbeitung erfolgt blockweise, wobei ein Block sich aus einem oder mehreren Codewörtern zusammensetzt. Die Blockgröße definiert dabei die Interleaver-Länge. Häufig werden hierbei systematische FEC-Codes eingesetzt; Der Datenblock enthält hierbei Nutzinformationen (= die zu übertragende Information) und zusätzliche Redundanz, um Übertragungsfehler korrigieren zu können.

Es sind verschiedene Arten von Blockinterleavern bekannt.

- Das Grundprinzip eines Blockinterleavers ist, dass die Elemente eines Datenvektors oder Matrix permutiert, d.h. vertauscht, werden.

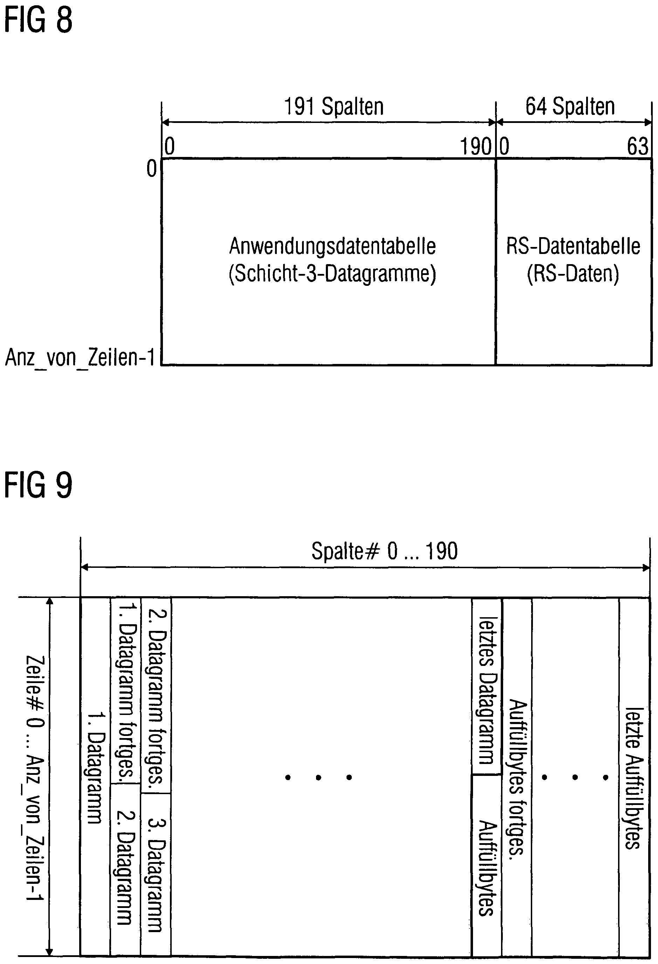

- Am bekanntesten ist die Variante, dass der Block als Matrix aufgefasst wird. Eine Zeile bildet dabei z.B. ein Codewort (z.B. ein Reed-Solomon Codewort). Die Information wird dann im Sender/Interleaver zeilenweise in die Matrix kopiert und spaltenweise ausgelesen. Beispielhaft sei hier die Methode aus dem ETSI Standard EN301192 erwähnt, die in Fig. 8 dargestellt ist.

Fig. 9 zeigt die Anordnung der Nutzdaten ("Application data"). Das Auslesen bzw. die Übertragung erfolgt dann in Datagrammen (datagram), wobei in Fig. 9 ferner eine Matrixanordnung in Zeilen (rows) gezeigt ist, wobei die Matrix eine Anzahl von Zeilen hat, die gleich "no_of_rows" ist. Ferner ist beispielhaft eine Anzahl von Spalten (columns) gezeigt, die sich von einer Nummer 0 bis zu einer Nummer 190 erstrecken. Um die Matrix aufzufüllen, werden nach dem letzten Datagramm (last datagram) sogenannte Auffüllbytes (Padding bytes) hinzugefügt, die sich fortsetzen (cont. = continued = fortgesetzt), und zwar bis zu den letzten Padding Bytes (last Padding bytes).

Die Interleaver-Eigenschaften können u.a. durch folgende Parameter charakterisiert werden:

- End-to-end Delay:
Dieser Parameter definiert den Zeitraum zwischen dem Zeitpunkt, wenn das Symbol am Eingang des Interleavers verfügbar ist, bis zum Zeitpunkt, wenn dieses Symbol am Ausgang des De-Interleavers verfügbar ist.
- (Receiver) Access-Time
Zeitraum zwischen dem Zeitpunkt, wenn das erste Symbol am Eingang des De-Interleavers verfügbar ist und dem Zeitpunkt, wenn das Codewort am Eingang des FEC-Decoders, also am Ausgang des De-Interleavers, verfügbar und decodierbar ist. Erfindungsgemäß muss man nur so lange warten, bis ein genügend großer Teil des Codeworts am Ausgang des De-Interleavers verfügbar ist, und nicht die komplette Zeit des End-to-End Delays, sofern die empfangenen Pakete genügend Signal-zu-Rausch Abstand besitzen. Dieser Parameter bestimmt z.B. bei einem Rundfunkempfänger die Zeit zwischen Einschalten des Empfängers oder Umschalten auf ein anderes Programm und Verfügbarkeit des Signals (z.B. Audio oder Videosignal) für den Benutzer. Das Decodieren z.B. eines Videosignals kann u.U. weitere Verzögerung bedeuten, die aber nicht in die Access Time eingehen sollte. Insofern sei angemerkt, dass ein Audio- oder Videodecoder weitere Verzögerung erzeugen könnte, die sich auch bei Diensten, die nicht zeit-interleaved sind, auswirkt.

- Speicherbedarf

Der Speicherbedarf wird bestimmt durch die Interleaverlänge und den Interleavertyp sowie die gewählte Repräsentation von Signalen im Sender oder Empfänger.

Die oben beschriebenen Interleaver-Konzepte zeichnen sich durch eine gute Verwürfelung sowohl innerhalb eines Codeworts oder Blocks als auch über Codewort-Grenzen hinaus in zeitlicher Hinsicht aus. Wie es in Fig. 7 dargestellt ist, wird durch die Verzögerungsglieder im Outer-Interleaver eine Veränderung der Reihenfolge der einzelnen Symbole in einem Codewort, das seriell in den eingangsseitigen De-Multiplexer hineinläuft, erreicht. Im Hinblick auf die Übertragung dieser Daten muss es sich hier jedoch nicht unbedingt um eine zeitliche Verwürfelung handeln, sondern es kann auch damit eine frequenzmäßige Verwürfelung erreicht werden. Eine frequenzmäßige Verwürfelung wird beispielsweise dann erreicht, wenn der vom Multiplexer am rechten Ende des Outer-Interleavers ausgegebene Datenstrom seriellparallel gewandelt wird und einem Satz von z.B. 1024 Trägern in einem OFDM-Symbol zugeordnet wird, so dass dann, wenn z.B. ein QPSK-Mapping verwendet wird, immer zwei Bits des ausgangsseitigen Datenstroms einem Träger zugeordnet werden, so dass eine OFDM-Belegung 2048 Bits aufnimmt, und zwar in der Reihenfolge, wie sie der äußere Interleaver erzeugt. Dies bedeutet natürlich dann, dass aufgrund der Verzögerungselemente im Outer-Interleaver Bits bzw. FEC-Symbole an anderen Trägern angeordnet werden, als sie angeordnet worden wären, wenn der Outer-Interleaver nicht vorhanden gewesen wäre.

Ein Faltungs-Interleaver bzw. Verschachtelungs-Interleaver mit Verzögerungen arbeitet somit je nach anschließender Implementierung entweder als Zeitinterleaver oder als Frequenz-Interleaver oder sowohl als Zeit- und Frequenz-Interleaver.

Nachteilig an der in Fig. 7 gezeigten Interleaver-Struktur ist die Tatsache des hohen Aufwands und des hohen Speicherbedarfs sowohl auf Sender-Seite als auch auf EmpfängerSeite. Dieser Nachteil wird immer gravierender, je größer die Codewörter werden, also je mehr Bits als Block in einen FEC-Codierer eingegeben werden, und je mehr Bits als Block aus dem FEC-Codierer, wie er z.B. in Fig. 6 gezeigt ist, ausgegeben werden. FEC-Codierer haben immer Coderaten kleiner als 1. Eine Coderate von beispielsweise 1/3 bedeutet, dass die Anzahl von Bits in einem von dem FEC-Codierer ausgegebenen Codewort dreimal so groß ist, wie die Anzahl der Bits in dem in den FEC-Codierer eingegebenen Eingangsblock bzw. Informationswort, wie es in Fig. 6 skizziert ist. Der Interleaver soll nunmehr eine möglichst gute zeitliche und frequenzmäßige Verwürfelung durchführen, so dass für jedes Bit bzw. für jedes Byte (abhängig vom Codierschema der FEC) eine Multiplexer-Steuerung bzw. allgemein gesagt eine eigene "Behandlung" erforderlich ist.

Dies zieht unmittelbar nach sich, dass auch auf Empfängerseite eine entsprechende De-Interleaver-Steuerung erforderlich ist. Ferner muss für jedes Bit bzw. für jedes Symbol zur Decodierung eine Qualitätsinformation, wie beispielsweise ein Wert für ein erreichtes Signal/Rausch-Verhältnis, für eine Bitfehlerwahrscheinlichkeit oder eine Wahrscheinlichkeit für den Wert des Bits bzw. Bytes erzeugt werden, wobei solche Wahrscheinlichkeiten insbesondere bei sogenannten Soft-Decodierern eingesetzt werden. Während dies bei relativ kleinen Codewörtern noch nicht so kritisch ist, wird die Problematik immer größer, je länger die Codewörter werden. Dies bedeutet, dass für eine reduzierte Senderkomplexität und insbesondere für eine reduzierte Empfänger-Komplexität, die für Rundfunkanwendungen besonders entscheidend ist, da die Empfänger Massenprodukte sind und preisgünstig angeboten werden müssen, eigentlich eine kleine Codewortlänge erstrebenswert ist. Andererseits liefert eine größere Codewortlänge bei langsam zeitveränderlichen Kanaleigenschaften bessere Vorteile, da ein Codewort über einen längeren Zeitraum bzw. über einen größeren Frequenzbereich "verteilt" werden kann.

Die US5968200 offenbart eine Vorrichtung, die ein implizites Interleaving verwendet, um einen systematischen Interleaver zu erzeugen, der zu einer akzeptablen Blockfehlerrate führt, wobei unkorrigierte Fehlerbursts vom Deinterleaver verteilt werden. Hier wird der Senderspeicher unabhängig vom verwendeten Interleaving-Ansatz im Wesentlichen eliminiert. Dabei werden Block-Interleaving-Ansätze (regulär oder zufällig), Faltungs-Interleaving-Ansätze (regulär und zufällig) und Produkt-Interleaving-Ansätze beschrieben. Bei der impliziten Verschachtelung werden alle eingehenden Daten so behandelt, als ob sie vorverschachtelt und ohne Änderung ihrer Reihenfolge und im Wesentlichen unverzüglich direkt an ihr Ziel übertragen würden.

Die Aufgabe der vorliegenden Erfindung besteht darin, ein effizientes und damit gut handhabbares Übertragungskonzept zu schaffen, das jedoch auch für Kanäle mit langsam veränderlichen Kanaleigenschaften gute Ergebnisse liefert.

Diese Aufgabe wird durch einen Sender nach Patentanspruch 1, ein Verfahren zum Erzeugen eines Sendesignals nach Patentanspruch 8, einen Empfänger nach Patentanspruch 9, ein Verfahren zum Empfangen nach Patentanspruch 11, oder ein digitales Speichermedium nach Patentanspruch 12 gelöst.

Der vorliegenden Erfindung liegt die Erkenntnis zugrunde, dass eine gute Effizienz auch bei größer werdenden Codewörtern beibehalten werden kann, wenn die Interleaver-Vorrichtung, die die Aufgabe des Faltungs-Interleavers schafft, nicht FEC-Symbol-weise ein Interleaving durchführt, sondern mit Verschachtelungseinheiten (Interleaving Units bzw. IU) arbeitet, wobei eine Verschachtelungseinheit wenigstens zwei FEC-Symbole aufweist. Bei bestimmten FEC-Codierern ist ein FEC-Symbol ein Bit . In diesem Fall umfasst eine Verschachtelungseinheit wenigstens zwei Bits. Bei anderen FEC-Codierern ist ein FEC-Symbol ein Byte. Dann umfasst eine Verschachtelungseinheit wenigstens zwei Bytes. Das Codewort, das eine Sequenz von Verschachtelungseinheiten aufweist, wobei jeder Verschachtelungseinheit wenigstens zwei Symbole zugeordnet sind, wird somit in die Verschachtelungseinrichtung eingespeist, um ein verschachteltes Codewort zu erhalten, das eine veränderte Sequenz von Verschachtelungseinheiten aufweist. Insbesondere wird die Verschachtelung so durchgeführt, dass eine Reihenfolge der Symbole innerhalb einer Verschachtelungseinheit nicht verändert wird, während die Sequenz der Verschachtelungseinheiten so verändert wird, dass zwischen zwei Verschachtelungseinheiten ein und desselben Codeworts wenigstens eine Verschachtelungseinheit eines vorhergehenden oder nachfolgenden Codeworts angeordnet ist, oder das eine Reihenfolge von Verschachtelungseinheiten in dem verschachtelten Codewort zu einer Reihenfolge der Sequenz von Verschachtelungseinheiten des Codeworts vor der Verarbeitung durch die Verschachtelungseinrichtung unterschiedlich ist.

Die dadurch erreichte Verschachtelung ist skalierbar, da die Anzahl der Symbole in einer Verschachtelungseinheit beliebig eingestellt werden kann. Anders ausgedrückt kann bei einem fest vorhandenen bzw. fest ausgelegten Interleaver, der in Verschachtelungseinheiten und nicht mehr in Symbolen arbeitet, die Codewortlänge beliebig vergrößert oder verkleinert werden. Hierzu müssen die Interleaver-Strukturen nicht geändert werden. Es muss lediglich die Anzahl der Symbole in einer Verschachtelungseinheit verändert werden. Bei einer festen Anzahl von Interleaver-Taps kann ein größeres Codewort verarbeitet werden, wenn die Anzahl von Symbolen in einer Verschachtelungseinheit erhöht wird, während dann, wenn kleinere Codewörter zu verarbeiten sind, die Anzahl der Symbole in einer Verschachtelungseinheit reduziert werden kann. Je höher die Anzahl der Symbole in einer Verschachtelungseinheit wird, umso effizienter wird die Empfänger- und auch die Sender-seitige Verarbeitung. Andererseits kann mit höher werdender Anzahl von Symbolen in einer Verschachtelungseinheit die günstige Wirkung des Faltungs-Interleavings nachlassen. Dieser Effekt kann jedoch dadurch abgemildert werden, wenn dem Faltungs-Interleaver ein Block-Interleaver vorgeschaltet wird, der nicht Verschachtelungseinheiten-weise arbeitet, sondern der tatsächlich FEC-Symbol-weise ein Block-Interleaving durchführt, bevor die Verschachtelungseinheiten gebildet werden. Bei der vorliegenden Erfindung werden somit ein Block-Interleaver und ein Faltungs-Interleaver kombiniert, wobei der Block-Interleaver jedoch symbolweise über den gesamten Block arbeitet, während der Faltungs-Interleaver lediglich Verschachtelungseinheiten-weise und nicht symbolweise arbeitet.

Erfindungsgemäß kann der gesamte Empfänger nunmehr auf ein Verschachtelungseinheiten-weises Verarbeiten umgestellt werden. Es müssen daher Soft-Informationen, also Seiteninformationen, die einer empfangenen Verschachtelungseinheit zugeordnet sind, nicht mehr symbolweise, sondern nur noch Verschachtelungseinheiten-weise bestimmt werden. Wenn eine Verschachtelungseinheit beispielsweise acht Symbole hat, so bedeutet dies eine Reduktion des Empfänger-Aufwands um das 8-fache.

Darüber hinaus kann das Speichermanagement nicht nur auf Senderseite, sondern auch auf Empfängerseite erheblich vereinfacht werden, da Speicher wesentlich schneller in Bursts eingelesen und ausgelesen werden können, wobei ein Burst dann besonders effizient ist, wenn er benachbarte Speicheradressen betrifft. Da die Reihenfolge innerhalb einer Verschachtelungseinheit nicht verändert wird, kann daher eine Verschachtelungseinheit besonders effizient burstartig von einem Empfängerspeicher ausgelesen werden, um die Funktionalität des De-Interleavings durchzuführen. Es sind zwar die einzelnen Verschachtelungseinheiten an unterschiedlichen Speicheradressen angeordnet, die durchaus im Speicher weit verteilt sein können. Allerdings sind die Symbole innerhalb einer Verschachtelungseinheit zusammenhängend und damit auch zusammenhängend im Empfängerspeicher abgelegt, da der senderseitige Faltungs-Interleaver die Reihenfolge der Symbole innerhalb einer Verschachtelungseinheit nicht antastet.

Weitere Vorteile der vorliegenden Erfindung bestehen darin, dass empfängerseitig der Verwaltungsaufwand und der Speicheraufwand für die Seiteninformationen stark reduziert wird, da nur noch für eine Verschachtelungseinheit und nicht für jedes einzelne Symbol die Seiteninformationen erzeugt, verwaltet und eingesetzt werden müssen. Darüber hinaus kann auch in Verschachtelungseinheiten bestimmt werden, ob der Decodierer bei relativ guter Übertragungsqualität bereits nach einer bestimmten Zeit bzw. nach einer bestimmten Anzahl von empfangenen Verschachtelungseinheiten genug Daten hat, um eine fehlerarme oder fehlerfreie Decodierung durchzuführen. Dann können weitere Verschachtelungseinheiten ohne weiteres ignoriert werden und im Empfänger als sogenannte "Erasures" markiert werden. Dies führt zu einer erheblichen Reduktion des End-to-End-Delays.

Ferner kann ein effizientes Energiemanagement damit durchgeführt werden, da der Empfänger bzw. der relevante Teil des Empfängers in einen Schlaf-Modus gesetzt werden kann, da bereits genug Verschachtelungseinheiten zum korrekten Decodieren empfangen sind.

Darüber hinaus kann auch eine bessere Emfänger-Access-Time erreicht werden, da der Empfänger bereits dann bereit ist, wenn er genug Verschachtelungseinheiten hat und mit dem Decodieren beginnt und nicht erst dann bereit ist, wenn ein komplettes Codewort decodiert ist.

Vorzugsweise werden Eingangsblöcke, also Informationswörter mit einer Länge von mehr als 5000 Symbolen und vorzugsweise sogar mehr als 10.000 Symbolen eingesetzt. Bei einer Coderate von beispielsweise 1/3 liefert der FEC-Codierer dann Codewörter von mehr als 15.000 Symbolen. Generell wird eine Codewortgröße am Ausgang des FEC-Codierers von mehr als 10.000 Bits eingesetzt. Bevorzugte Verschachtelungseinheiten haben dann nicht nur wenigstens zwei Bits/Symbole, sondern wenigstens 100 Symbole, so dass eine Anzahl von Verschachtelungseinheiten pro Codewort kleiner als 200 ist und am besten im Bereich zwischen 10 und 50 liegt.

Bevorzugte Ausführungsbeispiele der vorliegenden Erfindung werden nachfolgend Bezug nehmend auf die beiliegenden Zeichnungen detailliert erläutert. Es zeigen:

Fig. 1    eine Prinzipdarstellung eines Interleaver-Konzepts;

Fig. 2    ein bevorzugtes Ausführungsbeispiel eines erfindungsgemäßen Senders;

Fig. 3    ein bevorzugtes Ausführungsbeispiel eines erfindungsgemäßen Empfängers;

Fig. 4    eine Funktionsdarstellung der Empfängerstruktur von Fig. 3;

Fig. 5    ein bevorzugtes Ausführungsbeispiel für eine Prozessor-Verarbeitungsroutine zur Erhöhung der Empfänger-Effizienz;

Fig. 6    eine Prinzipdarstellung einer Zusammenschaltung eines FEC-Codierers und eines Interleavers;

Fig. 7    einen Faltungsinterleaver aus DVB-T EN 300744;

Fig. 8    eine Block-Interleaver-Struktur nach EN 301192;

Fig. 9    eine Anordnung der Nutzdaten "Application data", wobei ein Auslesen bzw. ein Übertragen in Datagrammen erfolgt;

Fig. 10    ein bevorzugtes Ausführungsbeispiel einer Interleaver-Vorrichtung mit drei Gruppen von Verbindungsleitungen mit unterschiedlichen Verzögerungen;

Fig. 11    ein gleichmäßiges Interleaver-Profil; und

Fig. 12    ein gleichmäßig/Spät- (Equal/Late-) InterleaverProfil, das für einen Übertragungskanal mit guten Empfangsbedingungen geeignet ist und eine niedrige Access Time erlaubt (engl: Fast Access).

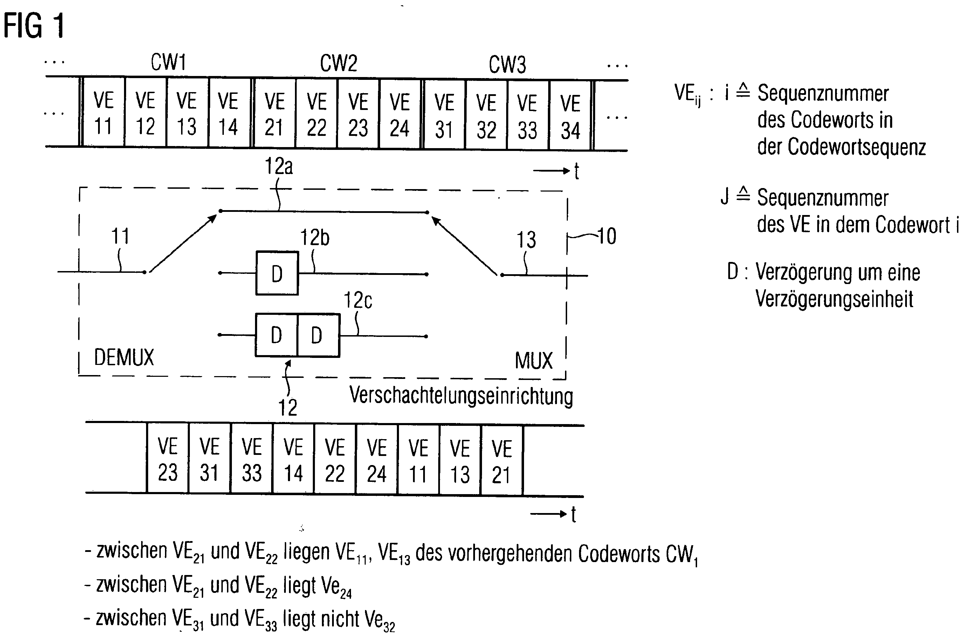

Bevor detailliert auf die einzelnen Figuren eingegangen wird, werden zunächst spezielle Vorteile der bevorzugten Interleaver-Vorrichtung, wie sie noch anhand von Fig. 1 erläutert werden wird, dargestellt. Insbesondere bei langen Faltungs-Interleavern ermöglicht die vorliegende Erfindung eine effiziente Realisierung, welche ihre besonderen Vorteile nicht nur in sich, sondern auch in Verbindung mit speziellen Decodierer-Strategien erhält.

Ziel der Erfindung ist eine Interleaverstruktur, die insbesondere bei sehr langen Zeitinterleavern eine effiziente Realisierung erlaubt. Die Struktur ist vorteilhaft in Zusammenhang mit den Decodier-Strategien.

Die Decodierstrategien können in folgende Gruppen unterteilt werden

-    Ohne Kanalzustandsinformation
     Fehler müssen ohne Zusatzinformation erkannt und korrigiert werden
-    Soft-Decoding
     Für jedes Bit oder Symbol kann die Wahrscheinlichkeit eines Übertragungsfehlers geschätzt werden.
-    Erasure Decoding
     Es ist bekannt, dass ein Symbol nicht empfangen wurde. Diese Form kann als Sonderfall des Soft-decoding verstanden werden. Für ein nicht empfangenes Bit oder Byte (oder ein Bit oder Byte mit extrem niedrigem Signal/Rauschverhältnis) wird quasi "geraten", d.h. es wird die Wahrscheinlichkeit, dass das Bit eine "0" oder eine "1" ist, auf jeweils 50% gesetzt.

Die gewählte Struktur bietet insbesondere Vorteile für Soft-decoding und Erasure-decoding. Die gewählte Struktur hat folgende Vorteile:

- Die für die Erasure- oder Soft-decoding notwendige Kanalzustandsinformation wird jeweils für einen Block (Interleaver-Unit = IU) gebildet und zusammen mit der IU gespeichert.

- Die Kanalzustandsinformation kann auch dazu verwendet werden, den Speicherbedarf zu reduzieren. So ist es z.B. denkbar, dass nur die Daten gespeichert werden, die eine ausreichende Signalqualität haben.

- Da im Receiver immer IU von mehreren Bits (typischerweise mindestens 100 oder mehr) als ein Block verwaltet werden, können z.B. moderne Speicherchips, die in der Regel einen Zugriff auf einen Datenblock effizienter unterstützen als eine wahlfreien Zugriff auf einzelne Speicherzellen, eingesetzt werden.

- Die Struktur erlaubt auch eine bessere Verwaltung des Speichers bei einem Programmwechsel oder nach Einschalten des Empfängers. Um zu vermeiden, dass Daten vom alten (= vorher gewählten Programm) und neuen Programm gemischt werden, muss bei einem Programmwechsel der Speicher gelöscht werden (oder es wird gewartet, bis der Speicher mit neuen Daten gefüllt ist). Bei der vorgeschlagenen Struktur reicht es, wenn nur die Kanalzustandsinformation auf "Erasure" gesetzt wird.

Die vorliegende Erfindung beschreibt eine Interleaverstruktur und zugehörige Decodierstrategien, die insbesondere für Systeme mit langen Zeitinterleavern relevant sind.

In Zusammenhang mit niederratigen fehlerkorrigierenden Codes erlaubt der Interleaver eine sichere Übertragung auch bei stark zeitveränderlichen Kanälen, wie sie z.B. bei Satellitenübertragungen oder auch zellularen terrestrischen Netzwerken typisch sind. Mit geeigneten Parametern und Decodierstrategien werden auch viele der typischen Nachteile von Interleavern reduziert, z.B. die höhere Access-Time und der höhere Speicherbedarf.

Dies wird dadurch erreicht, dass einerseits die Daten weiterhin als kleine Datenpakete (IU) verarbeitet werden. Das erlaubt (wie oben bereits erwähnt) eine effizientere Verwaltung der Daten. Um einen vollen Interleavergewinn zu erreichen, ist es aber vorteilhaft, wenn die Daten bitweise interleaved werden. Dies wird über einen sogenannten Mixer erreicht.

Durch die Verkettung der beiden Interleaver werden also die Vorteile eines bitweisen Interleavings mit der effizienteren Implementierung einer Datenpaket-orientierten Verarbeitung kombiniert.

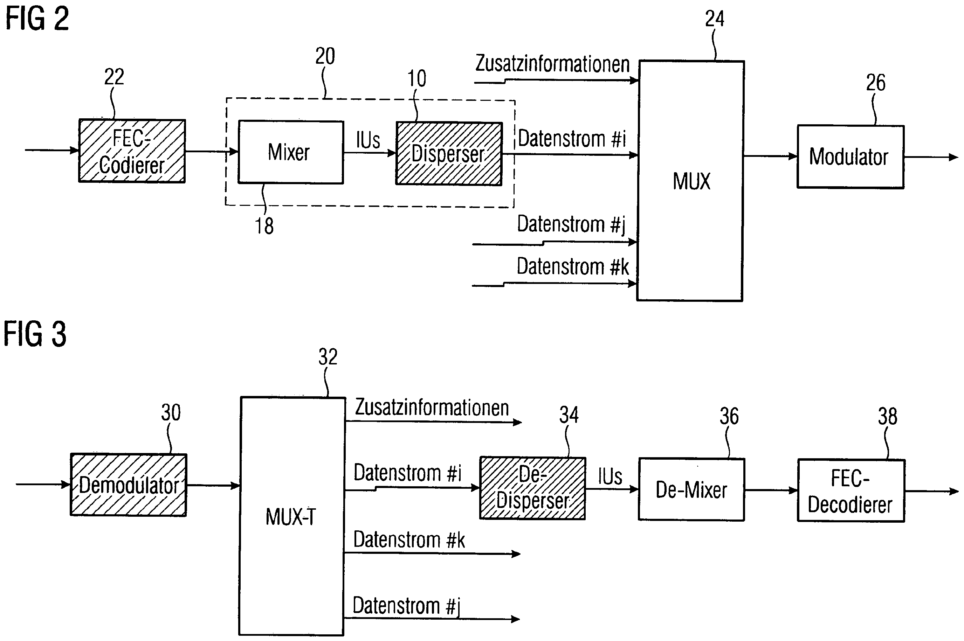

Fig. 1 zeigt eine Interleaver-Vorrichtung zum Verarbeiten mehrerer Codewörter CW1, CW2, CW3, die zeitlich sequenziell angeordnet sind und einen Strom von Ausgangsdaten aus einem FEC-Codierer, wie er beispielsweise in Fig. 6 gezeigt ist, bilden. Alternativ können die Codewörter auch bereits Codewörter sein, die von einem Block-Interleaver oder "Mixer", wie er noch Bezug nehmend auf Fig. 2 erläutert wird, ausgegeben werden. Jedes Codewort ist in eine Anzahl von Verschachtelungseinheiten VE eingeteilt, wobei lediglich der Notation halber jede Verschachtelungseinheit zwei Indices hat, nämlich den Index i und den Index j. Der Index i weist auf die Sequenznummer des Codeworts in der Codewortsequenz hin, während der Index j auf die Sequenznummer der Verschachtelungseinheit in dem Codewort i selbst hinweist. Wichtigerweise umfasst jede Verzögerungseinheit mehrere Symbole, also mehrere Bits oder Bytes je nach FEC-Codierer, wobei die Anzahl von Bits bzw. Bytes, also generell gesagt die Anzahl von Symbolen in einer Verschachtelungseinheit, gemäß der vorliegenden Erfindung größer als 50 und kleiner als 400 ist.

Darüber hinaus ist die Anzahl der Symbole in einer Verschachtelungseinheit abhängig von der Codewortlänge, so dass erfindungsgemäß jedes Codewort wenigstens 50 oder sogar noch mehr Verschachtelungseinheiten aufweist. Lediglich der Übersichtlichkeit halber sind bei dem in Fig. 1 gezeigten Ausführungsbeispiel Codewörter mit nur vier Verschachtelungseinheiten gezeigt.

Ein Codewort wird unter Verwendung einer Redundanzhinzufügenden Codierung von einem Eingangsblock von Symbolen in einem FEC-Codierer abgeleitet, wobei das Codewort mehr Symbole als der Eingangsblock aufweist, was gleichbedeutend mit der Aussage ist, dass die Coderate des Redundanz-hinzufügenden Codierers kleiner als 1 ist. Das Codewort weist eine Sequenz von Verschachtelungseinheiten auf, wobei jede Verschachtelungseinheit wenigstens zwei Symbole aufweist.

Die Interleaver-Vorrichtung umfasst als Herzstück eine Verschachtelungseinrichtung 10, die ausgebildet ist, um die Sequenz der Verschachtelungseinheiten in einem Codewort zu verändern, um ein verschachteltes Codewort zu erhalten, das eine veränderte Sequenz von Verschachtelungseinheiten aufweist. Insbesondere ist die Verschachtelungseinheit 10 ausgebildet, um eine Reihenfolge der Symbole innerhalb einer Verschachtelungseinheit nicht zu verändern, und um die Sequenz der Verschachtelungseinheiten so zu verändern, dass zwischen zwei Verschachtelungseinheiten des Codeworts wenigstens eine Verschachtelungseinheit eines vorhergehenden oder nachfolgenden Codeworts angeordnet ist, und/oder dass eine Reihenfolge von Verschachtelungseinheiten in dem verschachtelten Codewort zu einer Reihenfolge der Sequenz von Verschachtelungseinheiten unterschiedlich ist. Vorzugsweise ist die Verschachtelungseinrichtung ausgebildet, um einen Eingangs-De-Multiplexer 11, eine Mehrzahl von Verbindungsleitungen 12 und einen Ausgangsmultiplexer 13 zu haben. Der Eingangsmultiplexer ist ausgebildet, um nach Speisung einer Anzahl von kompletten Verschachtelungseinheiten in eine Verbindungsleitung zu einer anderen Verbindungsleitung umzuschlten, wobei die Anzahl von kompletten Verschachtelungseinheiten größer oder gleich 1 ist.

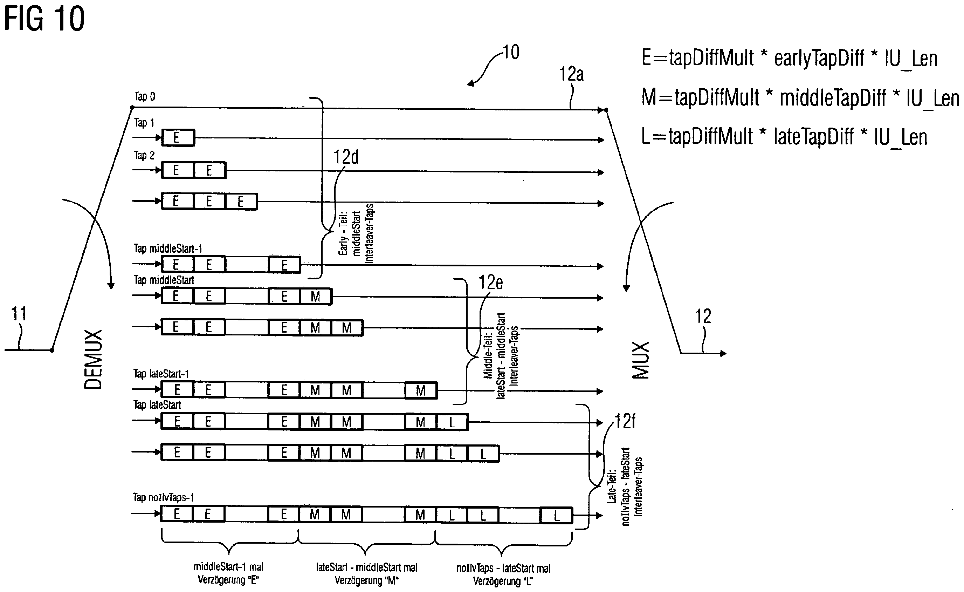

Ferner hat bei dem in Fig. 1 gezeigten Ausführungsbeispiel die erste Verbindungsleitung 12a einen Verzögerungswert von im Wesentlichen gleich Null. Es ist also kein eigenes Verzögerungsglied in Form eines FIFO-Speichers oder einer speziellen Verzögerungsleitung angeordnet. Dagegen hat die zweite Verbindungsleitung 12b eine definierte Verzögerung D, wobei die nächste Verbindungsleitung 12c eine weitere definierte Verzögerung hat, die durch die beiden Verzögerungs-Einrichtungen D gebildet wird, und die sich von der Verzögerung im Block 12b unterscheidet. Lediglich beispielhaft ist die Verzögerung in der Verbindungsleitung 12c doppelt so groß wie in der Verbindungsleitung 12b. Beliebige Verzögerungsverhältnisse können eingestellt werden, wobei jedoch ein ganzzahliges Raster zumindest unter einer bestimmten Anzahl von Verbindungsleitungen der Mehrzahl von Verbindungsleitungen bevorzugt wird, wie es später noch in Verbindung mit Fig. 10 ausgeführt wird, wobei das in Fig. 10 gezeigte Ausführungsbeispiel eine Mehrzahl von Verbindungsleitungen aufweist, die untereinander wenigstens zwei und in dem in Fig. 10 gezeigten Ausführungsbeispiel sogar drei Gruppen von Verbindungsleitungen aufweist, welche durch spezielle gemeinsame Verzögerungswerte gekennzeichnet sind.

Fig. 2 zeigt ein bevorzugtes Ausführungsbeispiel für einen Sender, wobei sich aus Fig. 2 auch die Einbettung der Interleaver-Vorrichtung von Fig. 1 in ein Senderkonzept ergibt. Die in Fig. 2 gezeigte Sendervorrichtung umfasst die Interleaver-Vorrichtung, die in Fig. 2 mit 20 bezeichnet ist, sowie einen vorgeschalteten FEC-Codierer 22 sowie einen nachgeschalteten Multiplexer 24 und einen dem Multiplexer nachgeschalteten Modulator 26. Die Interleaver-Vorrichtung 20 umfasst bei dem in Fig. 2 gezeigten bevorzugten Ausführungsbeispiel die Verschachtelungseinheit 10, die in Fig. 1 gezeigt ist. Diese Verschachtelungseinheit 10 ist in Fig. 2 als "Disperser" bezeichnet, hat jedoch prinzipiell dieselbe Funktionalität wie die Verschachtelungseinheit 10 in Fig. 1. Dem Disperser 10 vorgeschaltet ist ein Mixer 18, der bei der Interleaver-Vorrichtung 20 ebenfalls enthalten ist, um vor der Verschachtelungseinheitenweisen Verarbeitung im Disperser eine Block-Interleaving-Funktion durchzuführen, bei der ein Symbol-weises Interleaving, also ein Verändern der Reihenfolge der Symbole in einem Codewort, das vom FEC-Codierer 22 ausgegeben wird, durchgeführt wird.

Die dazu komplementäre Empfänger-Struktur ist in Fig. 3 gezeigt. Das Eingangssignal wird einem Demodulator 30 zugeführt, der einen Demultiplexer 32 speist, der aus dem Eingangssignal Zusatzinformationen und diverse Datenströme extrahieren kann. Lediglich beispielhaft ist die Verarbeitung des Datenstroms mit der Nummer i dargestellt, wobei dieser Datenstrom der Datenstrom ist, der bei dem in Fig. 2 gezeigten Beispiel erzeugt worden ist. Die Verarbeitung auf Senderseite und auf Empfängerseite für andere Datenströme k, j, welche beispielsweise andere Rundfunk- oder Fernsehprogramme oder andere Gespräche sind, kann genauso wie die Verarbeitung des Datenstroms i auf Sender- und auf Empfängerseite stattfinden. Der Datenstrom i, der vom Demultiplexer 32 extrahiert worden ist, wird einem De-Disperser 34 zugeführt, welcher Verschachtelungseinheiten (IUs) einem De-Mixer 36 zuführt, der dann die einzelnen Codewörter wiederherstellt, die dann einen FEC-Decodierer 38 zugeführt werden können, um wieder, wenn die Übertragungsqualität ausreichend war bzw. wenn genug Redundanz hinzugefügt worden ist, ein Abbild des Eingangsblocks von Symbolen erzeugt, der - abgesehen von Bitfehlern - identisch zu dem Eingangsblock von Symbolen ist, der auf Senderseite in den FEC-Codierer 22 von Fig. 2 eingespeist worden ist.

Der FEC-Codierer 22 dient zur Redundanz-Hinzufügung zu dem Eingangssignal. Hierfür sind z.B. leistungsfähige Codes, wie Turbo-Codes, wie sie z.B. aus dem 3GPP2-Standard bekannt sind, oder LDPC-Codes, wie sie beispielsweise aus dem DVB-S2-Standard bekannt sind, geeignet. Es können aber auch andere Codes eingesetzt werden. Der Ausgang des FEC-Codierers 22 ist ein Codewort. Vorteilhaft für die Übertragungsqualität ist die Verwendung von relativ langen Codewörtern, die typischerweise größer als 10.000 Bits sind.

Der Mixer 20 ist eine Art Block-Interleaver, der symbolweise, also bitweise oder byteweise die Reihenfolge der Bits innerhalb eines Codeworts vertauscht. Hierauf findet ein Demultiplexen in Interleaver-Units bzw. Verschachtelungseinheiten statt. Der Ausgang des Mixers wird in Verschachtelungseinheiten (IUs) unterteilt. Eine Interleaver-Unit ist eine Gruppe von Bits oder Bytes bzw. allgemein eine Gruppe von Symbolen. Typischerweise sollte ein Codewort in ca. 20 Interleaver-Units oder mehr unterteilt werden. Bei einer Codewortgröße von mehr als 10.000 Bits ergeben sich dann 200 oder mehr Bits pro Verschachtelungseinheit.

Der Disperser 10 stellt eine Art Faltungs-Interleaver dar, der dazu dient, die Interleaver-Units in der Zeit zu verteilen. Im Gegensatz zu normalen Faltungs-Interleavern erfolgt die Umschaltung nicht Bit- oder symbolweise, sondern Verschachtelungseinheiten-weise.

Der Ausgang des Dispersers 10 wird dann gegebenenfalls mit anderen Daten, wie es in Fig. 2 gezeigt ist, also Zusatzinformationen, anderen Programmen oder Programm-Gruppen gemultiplext.

Der Modulator 26 erzeugt daraus dann ein HF-Signal. Es können unterschiedliche Modulatoren verwendet werden. Beispielhaft sind hier lediglich OFDM oder eine Trägermodulation mit n-PSK-Modulation genannt.

Der in Fig. 3 gezeigte Empfänger umfasst den Demodulator 30, der eine zugehörige Synchronisationseinrichtung aufweist. Ferner wird gegebenenfalls eine Rahmensynchronisation durchgeführt, falls der Demodulator keine Rahmenstruktur verwendet oder eine andere Rahmenlänge benutzt. Die Rahmensynchronisation dient zur Synchronisation des DeMultiplexers und des De-Interleavers.

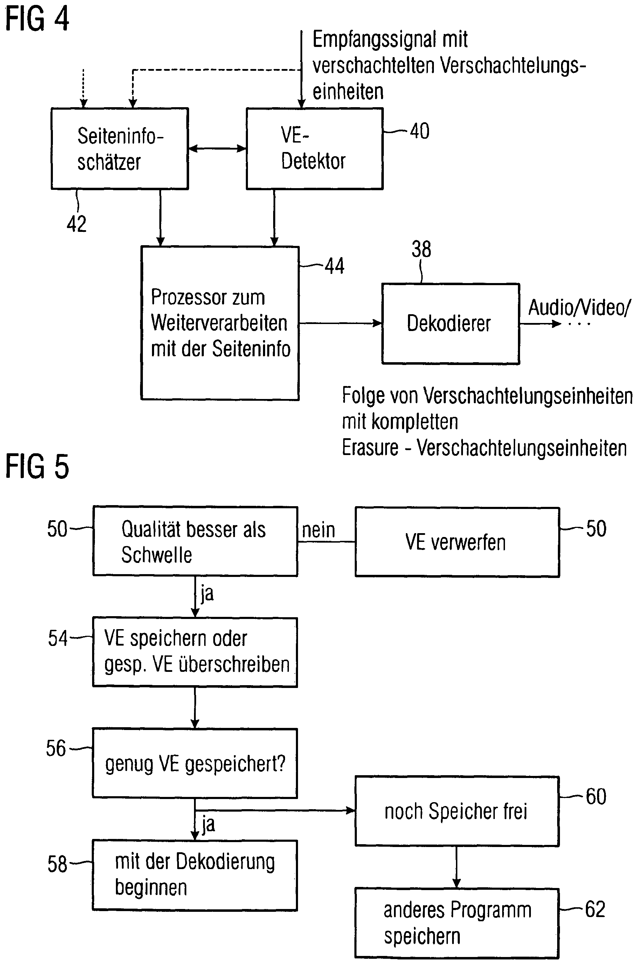

Der De-Multiplexer 32 liefert an seinem Ausgang einen Datenstrom mit einer Folge von Verschachtelungseinheiten. Ferner wird noch eine Kanalzustandsschätzung durchgeführt, wie sie noch Bezug nehmend auf Fig. 4 erläutert wird. Hierbei wird nicht symbolweise, sondern Verschachtelungseinheiten-weise der Kanalzustand geschätzt bzw. - allgemein gesagt - eine Empfangsqualitätsinformation pro Verschachtelungseinheit geliefert, die irgendwie eine Aussage über die Verlässlichkeit bzw. Empfangsqualität einer Verschachtelungseinheit insgesamt liefert. Solche Empfangsqualitätsinformationen sind Kanalzustände, Signal-Rausch-Verhältnisse, Bitfehlerraten etc. Pro Symbol werden keine Empfangsqualitätsinformationen ermittelt oder verwendet.

Der Datenstrom wird in den De-Disperser eingespeist, auf den noch eingegangen wird, und der beispielsweise mittels einer Speicherverwaltung implementiert ist. Am Ausgang des De-Dispersers wird ein Multiplex durchgeführt, um aus den Verschachtelungseinheiten am Ausgang des De-Dispersers wieder Codewörter zu erzeugen, die dann in einem De-Mixer 36 einem Block-De-Interleaving unterzogen werden, um dann schließlich in dem FEC-Decodierer 38 eine Decodierung durchzuführen, beispielsweise eine Viterbi-Decodierung oder irgendeine andere Art und Weise der Decodierung. Allgemein gesagt führt der De-Disperser 34 eine zu der Funktionalität des Dispersers 10 komplementäre Operation durch, und führt der De-Mixer 36 eine zur Operation des Mixers 18 komplementäre Operation durch. Die empfängerseitigen Elemente 34 und 36 müssen jedoch nicht immer gesamte Codewörter verarbeiten, sondern können auch bestimmte Verschachtelungseinheiten, wie es nachfolgend noch dargelegt wird, durch Erasures ersetzen, so dass dann die De-Interleaver-Operationen der Elemente 34 und 36 unter Verwendung von Erasure-Informationen und nicht unter Verwendung von tatsächlich empfangenen Verschachtelungseinheiten durchgeführt werden.

Nachfolgend wird detaillierter auf den Mixer 18 eingegangen.

Der Mixer ist ein Blockinterleaver, der die Bits innerhalb eines kürzeren Blocks, z.B. eines Codewortes, permutiert.

Der De-Mixer dient bei einem Interleaver-Schema mit einem Disperser dazu, die Burstfehler, die nach dem De-Dipserser wegen des IU-weisen De-Interleavings zwangsweise auftreten, möglichst günstig über einen Block zu verteilen, z.B. gleichmäßig über ein Codewort, damit der Decodiervorgang bessere Ergebnisse liefert.

In einem Ausführungsbeispiel erfolgt das Interleaven von Eingangsbits a[i] zu Ausgangsbits b[i] entsprechend der folgenden Formel:

$$b[i] = a[\ (CILM\_Inc\ *\ i)\ mod\ codewordLen],$$

wobei

codewordLen die Codewortlänge,
CILM_Inc ein konfigurierbarer Parameter und
mod die modulo-Operation

ist.

Nachfolgend wird auf den Disperser 10 von Fig. 2, wie er allgemein gesagt auch in Fig. 1 dargestellt ist, eingegangen.

Der eigentliche Zeitinterleaver (ggf. auch als Frequenzinterleaver eingesetzt) ist der Disperser. Er verteilt die vom Mixer ausgegebenen Blöcke (z.B. Codewörter) über die Zeit (und/oder über die Frequenz). Beim Disperser handelt es sich um einen Faltungsinterleaver, der nicht Bit-, sondern Blockweise arbeitet. Wegen der blockweisen Funktionsweise ist die Verwendung eines Mixers sinnvoll (s.o.).

Die Vorteile des blockweisen Interleavens sind u. a. im Empfänger zu sehen:

- das De-Interleaven erfolgt in der Regel durch Abspeichern der eingehenden Daten in einem Zwischenspeicher und darauffolgendes Lesen in der de-interleaveten Reihenfolge. Ein blockweises Abspeichern und Lesen ermöglicht eine effiziente Ansteuerung des Speichers. Dynamisches Random Access Memory (RAM) kann nämlich weit schneller in Bursts beschrieben und gelesen werden, als wenn unzusammenhängend auf einzelne Bytes zugegriffen wird. Dadurch kann beim Blockweisen Interleaven (a) ein langsamerer/günstigerer Speicher als beim bitweisen Interleaven, oder (b) der Speicher kann besser mit anderen Nutzern geteilt werden (Arbitrierung eines Shared Memory), so dass weniger Speicherbausteine nötig sind. In beiden Fällen ist eine Kostenersparnis erreichbar.

- die Verwaltung der Empfangsdaten im De-Interleaver erfolgt effizienter: Kanalzustandsinformation (z.B. die Schätzung des Signal-Rausch-Verhältnisses) muss nur noch pro IU statt für jedes Symbol/Bit abgespeichert werden; dadurch wird Speicherplatz gespart. Zudem ermöglicht eine IU-weise Speicherung, dass das Interleaver-Management einzelne IUs löscht, wenn sie nicht benötigt werden, z.B. wenn von einem Codewort genügend "gute" IUs (wenig gestört) empfangen worden sind, dann brauchen "schlechte" IUs nicht mehr gespeichert zu werden und bereits empfangene können mittels eines intelligenten Interleaver-Managements leicht freigegeben werden. Intelligentes Interleaver-Management bedeutet hierbei, dass eine Interleaver-Kontroll-Einheit in einer Tabelle über jede gespeicherte IU Seiteninformation aufbewahrt, um das Decodierergebnis und den benötigten Speicher zu optimieren. Die Interleaver-Kontroll-Einheit kann stets feststellen, welche IU im weiteren Decodierverlauf benötigt werden und welche nicht. Für die Decodierung müssen die nicht gespeicherten IUs durch Erasures ersetzt werden. Der De-Mixer erhält deshalb für diese IUs eine Anzahl von Erasures vom De-Disperser.

Fig. 10 zeigt die prinzipielle Struktur des Faltungsinterleavers im Disperser für ein Ausführungsbeispiel. Der gezeigte Interleaver besitzt unregelmäßige Verzögerungsleitungen.

Der Disperser besteht aus noIlvTaps parallelen Verzögerungsleitungen, wobei noIlvTaps der Blockgröße am Mixer-Ausgang geteilt durch die Größe einer IU (im folgenden IU_Len) entspricht. Die Leitungen werden nacheinander von einem Demultiplexer (DEMUX) gefüttert. Der Eingang dieses Demultiplexers ist ein Strom von Codebits bzw. Symbolen vom Ausgang des Mixers. Der DEMUX füttert jede Verzögerungsleitung mit exakt einer Interleaver Unit (IU), die IU_Len Codebits bzw. Symbole vom Ausgang des Mixers entspricht. Dann schaltet der DEMUX zur nächsten Leitung und so weiter. Am Start eines Blocks, der vom Mixer verarbeitet wurde (z.B. eines Codewortes), schaltet der DEMUX immer zur ersten Leitung (Index 0). Das Ende eines Blocks ist erreicht, wenn der DEMUX eine IU in die letzte Leitung (index noIlvTaps-1) gefüttert hat.

Der gezeigte Interleaver kann über die 7 Parameter noIlvTaps, middleStart, lateStart, tapDiffMult, earlyTapDiff, middleTapDiff, lateTapDiff konfiguriert werden.

Jede Leitung enthält Verzögerungselemente. Es gibt drei mögliche Elemente, wie man in Fig. 10 sehen kann:

- Verzögerung "E" enthält tapDiffMult * earlyTapDiff IUs (also tapDiffMult * earlyTapDiff * IU_Len Bits/Symbole)
- Verzögerung "M" enthält tapDiffMult * middleTapDiff IUs
- Verzögerung "L" enthält tapDiffMult * lateTapDiff IUs

Am Ausgang der Leitungen sammelt ein Multiplexer (MUX) die Ausgänge der Verzögerungselemente. Sein Umschalten der Leitungen ist perfekt auf den DEMUX synchronisiert.

Der Ausgang des MUX ist also ein Strom von IUs der interleaveten Blöcke bzw. Codewörter.

Die IUs in der ersten Leitung (Index 0) sind immer unverzögert. Alle anderen IUs mit Index 0 < i < noIlvTaps des Blocks/Codeworts sind bzgl. der ersten IU wie folgt verzögert (siehe auch Fig. 10):

○ für 0 <= i < middleStart: ist die Verzögerung in Blöcken/Codewörtern i * tapDiffMult * earlyTapDiff

○ für middleStart <= i < lateStart: die Verzögerung in Blöcken/Codewörtern ist (middleStart-1) * tapDiffMult * earlyTapDiff + (i - middleStart+1) * tapDiffMult * middleTapDiff

○ für lateStart <= i < noIlvTaps: die Verzögerung in Blöcken/Codewörtern ist (middleStart-1) * tapDiffMult * earlyTapDiff + (lateStart - middleStart) * tapDiffMult * middleTapDiff + (i - lateStart+1) * tapDiffMult * lateTapDiff

Deshalb werden die ersten middleStart IUs ("Early-Teil") des Blocks/Codeworts anders in der Zeit verteilt als die mittleren (lateStart - middleStart) IUs ("Middle-Teil") und die letzten (noIlvTaps - lateStart) IUs sind wieder anders verteilt:

- der Abstand zwischen IUs des Early-Teils, die vor dem Interleaven zum selben Block/Codewort gehörten, ist anschließend tapDiffMult * earlyTapDiff,

- der Abstand zwischen IUs des Middle-Teils ist tapDiffMult * middleTapDiff Blöcke/Codewörter

- der Abstand zwischen IUs des Late-Teils ist tapDiffMult * lateTapDiff Blöcke/Codewörter,

Durch Konfiguration der 7 Interleaverparameter ist es möglich, das passende Interleaver-Profil auszuwählen, d.h. eine günstige Verteilung des Inhalts eines Blocks/Codeworts über die Zeit (und/oder Frequenz). Man kann z.B. viele IUs mit einer kurzen Verzögerung im Late-Teil übertragen, falls das wünschenswert ist, oder man kann die IUs gleichmäßig über eine gegebene Zeitdauer verteilen, oder man kann beides kombinieren usw.

Fig. 10 zeigt ein bevorzugtes Ausführungsbeispiel der vorstehend beschriebenen Interleaver-Vorrichtung, die auch als Disperser bezeichnet wird. Im Einzelnen umfasst die in Fig. 10 gezeigte Interleaver-Vorrichtung bzw. die Verschachtelungseinrichtung der Interleaver-Vorrichtung den Eingangs-Multiplexer 11, der als De-Multiplexer ausgebildet ist, und als DEMUX in Fig. 10 bezeichnet ist. Ferner ist der Ausgangsmultiplexer 12 vorhanden, der als MUX in Fig. 10 bezeichnet ist. Zwischen den beiden Multiplexern 11 und 12 befindet sich eine Mehrzahl von Verbindungleitungen, die bei dem in Fig. 10 gezeigten Ausführungsbeispiel, wie es bereits beschrieben worden ist, in drei Gruppen aufgeteilt sind. Die erste Gruppe ist der Early Part 12d. Die zweite Gruppe ist der Middle Part 12e und die dritte Gruppe ist der Late Part 12f.

Jede Verzögerungsleitung bzw. Verbindungsleitung mit Verzögerung außer der aller ersten Verbindungsleitung 12a hat eine bestimmte Verzögerungseinheit, wobei die Verzögerungseinheiten jedoch in den drei Gruppen unterschiedlich konfiguriert werden können, und zwar über den Parameter earlyTapDiff für die Gruppe 12d, über den Paramter middleTapDiff für die Gruppe 124 und den Parameter lateTapDiff für die Gruppe 12f.

Ferner ist in Fig. 10 gezeigt, dass die Verzögerung von Verbindungsleitung (Tap) zu Verbindungsleitung, um ein Inkrement (E, M oder L) zunimmt, so dass z.B. die Verbindungsleitung Tap middleStart-1 eine Anzahl von Tap middleStart-1 Verzögerungselemente E hat. Ferner hat jede Verbindungsleitung der zweiten Gruppe 12e dieselbe Anzahl von Verzögerungseinheiten E wie die letzte Verbindungsleitung der ersten Gruppe sowie zusätzlich eine von Verbindungsleitung zu Verbindungsleitung zunehmende Anzahl von M-Verzögerungen. Entsprechend hat auch jede Verbindungsleitung der Late-Gruppe dieselbe Anzahl von E Verzögerungen wie die letzte Verbindungsleitung der ersten Gruppe und dieselbe Anzahl von M Verzögerungen wie die letzte Verbindungsleitung der zweiten Gruppe sowie eine von Verbindungsleitung zu Verbindungsleitung zunehmende Anzahl von L-Verzögerungselementen.

Sowohl die erste Gruppe als auch die zweite Gruppe als auch die dritte Gruppe umfassen Verbindungsleitungen, wobei jede dieser Verbindungsleitungen außer der aller ersten Verbindungsleitung der ersten Gruppe eine definierte Verzögerungsmenge oder ein ganzzahliges Vielfaches der definierten Verzögerungsmenge hat, wobei sich die definierte Verzögerungsmenge, also das Inkrement E, M, L von Gruppe zu Gruppe unterscheiden können und, wichtigerweise, durch die einzelnen Steuerparameter, wie sie vorstehend ausgeführt worden sind, konfigurierbar sind. Es ist aus Fig. 10 und der Beschreibung von E, M und L ersichtlich, dass das Grundraster die Länge einer Verschachtelungseinheit, also IU_Len ist. Wenn eine Verschachtelungseinheit somit z.B. 20 Symbole hat, ist jede Verzögerung E, M, L ein ganzzahliges Vielfaches dieser Verzögerung, die einer Länge einer Verschachtelungseinheit IU_Len entspricht. Die Verzögerung, die einer gesamten Verschachtelungseinheit entspricht, ist gegeben durch die Periodendauer des Verarbeitungstakts multipliziert mit der Anzahl von Bits bzw. Symbolen, wobei im Falle der Verarbeitung von Bits der Takt ein Bittakt ist, und wobei im Falle der Verarbeitung von Bytes als Symbole der Takt ein Byte-Takt ist.

Nachfolgend wird ein spezielles Konfigurationsbeispiel dargestellt.

### FEC Parameter

Als FEC-Encoder wird ein Turbo Code entsprechend dem 3GPP2 Standard verwendet.

| | | |
|---|---|---|
| Bits pro Block am Eingang des FEC-Encoders (incl. 6 Tail bits) | 12288bits | bits |
| Code rate R | 1/4 | |
| Anzahl der Bits am Ausgang des FEC-Encoders | 49152bits | bits |
| Größe einer IU | 512bit | bits |
| Anzahl der IU pro Codewort | 96 | |

### Mixer-Konfiguration

codeWordLen ist 49152 bits und CILM_Inc ist 217.

### Disperser-Konfiguration

Die folgenden Unter-Kapitel zeigen verschiedene Konfigurationen, die unterschiedliche Interleaver-Profile und damit verschiedene Anwendungsfälle darstellen.

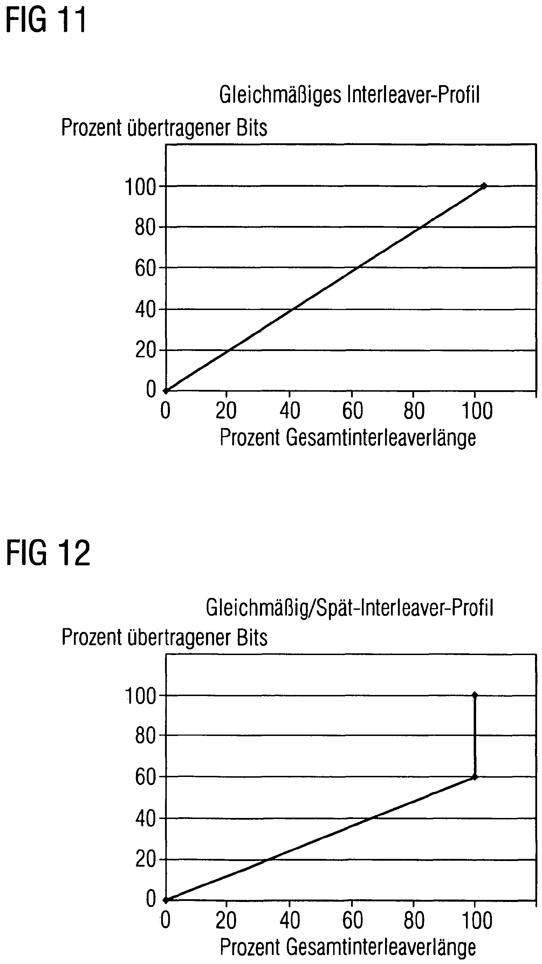

### Equal Spreading (Fig. 11)

Die zu einem Block (bzw. Codewort) gehörenden IUs sind gleichmäßig über die Zeit verteilt, d.h. der Abstand zwischen den IUs ist am Ausgang des Dispersers gleich.

Eine solche Konfiguration ist sinnvoll, wenn der Übertragungskanal zufällige kurze Aussetzer (schlechter Kanalzustand) produziert und dann quasi zufällig die einzelnen IUs stört. Insbesondere ist diese Konfiguration bei höheren Coderaten sinnvoll.

Eine mögliche Konfiguration ist, nur den Early-Teil zu verwenden, d.h. middleStart = noIlvTaps.

**Early/Late**

Die IUs eines Blocks werden in zwei Bursts übertragen (Early und Late) zwischen denen ein Zeitintervall liegt, in dem keine oder nur selten IUs dieses Blocks übertragen werden.

Diese Konfiguration sollte verwendet werden, wenn der Übertragungskanal sehr lange Aussetzer produziert (z.B. bei der Fahrt unter einer Brücke oder durch einen Tunnel). Dabei muss der Early bzw. der Late-Teil bei gutem Empfang alleine ausreichen, um den Block decodieren zu können. Ist dies der Fall, dann darf der Aussetzer maximal so lange sein wie das Intervall zwischen Early und Late, ohne dass es zu einem Versagen bei der Decodierung dieses Blocks kommt.

Zur Parametrierung dieser Konfiguration sollte middleStart und NoIlvTaps-lateStart (Anzahl in Early- bzw. Late-Teil) größer als lateStart-middleStart (Größe des Middle-Teils) sein. earlyTapDiff und lateTapDiff sollten für eine burstartige Übertragung zu Null gewählt werden, während tapDiffMult und middleTapDiff maximal sein sollten, um die IUs im Middle-Teil möglichst weit zu strecken.

**Equal/Late (Fig. 12)**

Ein Teil der IUs wird nach der Strategie "Equal Spreading" (s.o.) übertragen, der Rest kommt burstartig als Late-Teil.

In diesem Fall muss der Late-Teil ausreichend viele IUs umfassen, dass er alleine bei guten Empfangsbedingungen zur fehlerfreien Decodierung ausreicht. Somit ist dieses Interleaverprofil für Fast Access geeignet, so dass die Access Time trotz eines langen Interleavers niedrig gehalten werden kann. Die restlichen IUs im Equal-Teil sollen den Schutz vor zufälligen Ausfällen von IUs bieten (siehe "Equal Spreading").

Die Parametrierung kann ähnlich zu oben für die Early-, Middle- und Late-Teile erfolgen.

**Early/Equal**

Diese Konfiguration ist zeitlich gespiegelt zur "Equal/Late"-Konfiguration, d.h. es gibt einen burstartigen Early-Teil gefolgt von "Equal Spreading" für die restlichen IUs.

Der Vorteil ist hier, dass das End-to-End-Delay niedrig ist. Bestenfalls kann bereits nach Empfang des Early-Teils decodiert werden, also kurz nachdem die zugehörige Information in den Sender eingegeben wurde.

Fig. 5 zeigt eine Funktionsimplementierung der erfindungsgemäßen Empfängeranordnung. Diese empfängt ein Empfangssignal mit verschachtelten Verschachtelungseinheiten, wie sie vom Multiplexer 32 z.B. aus dem Datenstrom mit der Nummer i in Fig. 3 ausgegeben und in den De-Disperser 34 eingegeben wird. Diese verschachtelten Verschachtelungseinheiten werden in einen Verschachtelungseinheiten-Detektor 40 eingegeben, der ausgebildet ist, um Verschachtelungseinheiten aus dem Signal zu empfangen. Die detektierten Verschachtelungseinheiten werden benötigt, um den De-Disperser 34 korrekt anzusteuern. Ferner ist erfindungsgemäß ein Seiteninformationen-Schätzer 42 angeordnet, der entweder nur mit dem Verschachtelungseinheiten-Detektor 40 kommuniziert, oder der zusätzlich das Empfangssignal erhält, oder der von einer anderen Vorrichtung, wie beispielsweise einem Kanalschätzer angesteuert werden kann. Der Seiteninformationen-Schätzer ist ausgebildet, um eine auf eine Übertragung der gesamten Verschachtelungseinheiten bezogene Seiteninformation für eine extrahierte Verschachtelungseinheit zu schätzen. Der Seiteninformationen-Schätzer 42 und der Verschachtelungseinheiten-Detektor 40 speisen einen Prozessor 44 zum Weiterverarbeiten der Verschachtelungseinheiten unter Verwendung der für eine gesamte Verschachtelungseinheit ermittelten Seiteninformationen, die von dem Block 42 geliefert werden. Der Prozessor 44 vereinigt daher bei dem bevorzugten Ausführungsbeispiel die Funktionalitäten des De-Dispersers 34 und des De-Mixers 36 von Fig. 3. Allerdings umfasst er bei bevorzugten Ausführungsbeispielen der vorliegenden Erfindung noch weitere Funktionalitäten, um die Effizienz des Empfängers zu steigern, wie sie bezugnehmend auf Fig. 5 erläutert werden.

Im einzelnen prüft der Prozessor 44 dann, wenn er die Seiteninformationen für eine Verschachtelungseinheit erhalten hat, ob der Verschachtelungseinheit eine Empfangsqualität zugewiesen ist, die besser als eine Schwelle ist (Schritt 50). Wird diese Frage mit nein beantwortet, so wird die gesamte Verschachtelungseinheit verworfen (Schritt 52), was z.B. dadurch konkret implementiert werden kann, dass in einem Speicher nichts abgespeichert wird, sondern dass dann wenn das De-Dispersing stattfindet, die verworfenen Verschachtelungseinheiten einfach mit Erasures gekennzeichnet werden, also z. B. mit Wahrscheinlichkeitsinformationen, die eine 50 %-ige Wahrscheinlichkeit für eine 0 oder eine 1 signalisieren.

Wird jedoch die Frage im Schritt 50 mit ja beantwortet, so wird eine solche Verschachtelungseinheit, wie es im Schritt 54 ausgeführt ist, in einem Empfänger-Speicher gespeichert, welcher die De-Disperser-Funktionalität 34 dadurch implementiert, dass der Speicher anders ausgelesen wird als er beschrieben worden ist. Wurde jedoch bereits festgestellt, dass genug qualitativ gute Verschachtelungseinheiten für ein Codewort empfangen worden sind, derart, dass bereits eine korrekte Decodierung des Codeworts durchgeführt werden kann, ohne sämtliche Verschachtelungseirlheiten des Codewortes zu empfangen, so wird überprüft, ob in dem Empfänger-Speicher eine Verschachtelungseinheit gespeichert ist, die eine schlechtere Qualität als die gerade betrachtete Verschachtelungseinheit hat. Wenn eine solche Verschachtelungseinheit gefunden wird, wird sie mit der aktuell erfassten neueren besser-qualitativen Verschachtelungseinheit überschrieben. Wird allerdings festgestellt, dass alle gespeicherten Verschachtelungseinheiten eine bessere Qualität haben, und wird zudem festgestellt, dass bereits genug Verschachtelungseinheiten empfangen worden sind, so wird die Verschachtelungseinheit, die aufgrund der geschätzten Seiteninformationen eine relativ gute Qualität hat, dennoch verworfen, da sie nicht mehr benötigt wird.

Insofern wird in einem Schritt 56 überprüft, ob genug Verschachtelungseinheiten gespeichert sind, also ob bereits eine korrekte Decodierung eines Codeworts erfolgen kann. Wird diese Frage mit ja beantwortet, so wird in einem Schritt 58 mit der Decodierung begonnen, wird also das Codewort dem De-Mixer 36 zugeführt, wenn ein solcher De-Mixer vorhanden ist, oder wird das Codewort, wenn ein De-Mixer 36 von Fig.3 nicht vorhanden ist, direkt in den FEC-Decodierer 38 eingespeist, wobei für Verschachtelungseinheiten, die verworfen oder nicht mehr abgespeichert worden sind, Erasures eingesetzt werden. Wird gleichzeitig in einem Schritt 60 festgestellt, dass noch Speicher frei ist, so kann in diesem Empfängerspeicher zur Verbesserung der bei einer Programmumschaltung anfallenden Zeitdauer bereits im Speicher damit begonnen werden, parallel Verschachtelungseinheiten eines anderen Programms zu speichern (Schritt 62), so dass - im optimalen Fall - im Speicher das zweite Programm ebenfalls komplett codewort-mäßig abgespeichert ist, derart, dass eine Umschaltung von einem Programm zu einem anderen Programm unmittelbar erfolgt, also ohne ein durch den langen Faltungs-Interleaver eigentlich vorgegebenes End-to-End-Delay.

All dies wird möglich, da erfindungsgemäß nunmehr nicht mehr symbolweise bzw. bitweise gearbeitet wird, sondern Verschachtelungseinheiten-weise gearbeitet wird, so dass nur noch Qualitätsinformationen Verschachtelungseinheiten-weise verarbeitet werden müssen. Darüber hinaus kann Verschachtelungseinheiten-weise, also burstartig ein Empfangsspeicher ausgelesen werden, wodurch die De-Disperser-Operation nicht nur deutlich beschleunigt wird, wenn ein normaler RAM-Speicher verwendet wird, sondern wodurch auch eine Auslesungs-Verbesserung stattfindet, wenn irgendein anderer Speicher verwendet wird, da in einem Burst benachbarte Speicheradressen ausgelesen werden können, um die einzelnen Symbole, die in einer Verschachtelungseinheit vorhanden sind, zu gewinnen, so dass die De-Disperser-Operation ausgeführt wird. Des weiteren kann eine übersichtliche Signalisierung beibehalten werden, da die Anzahl der zu verwaltenden Zeitinformationen nicht mehr bitweise erzeugt, verwaltet und angewendet werden muss, sondern nur noch Verschachtelungseinheiten-weise, was dann, wenn eine Verschachtelungseinheit z.B. 128 Bits oder mehr aufweist, zu einer 128-fachen Reduzierung der zu verwaltenden Informationen beiträgt. So wird zwar die Genauigkeit reduziert, da man nicht mehr Qualitätsinformationen pro Bit, sondern nur noch pro Verschachtelungseinheit also in gröberer Granularität hat. Dies ist allerdings unkritisch, da eine derart genaue Qualitätsinformation nicht benötigt bzw. solche Qualitätsinformationen ohnehin in dieser feinen Granularität nicht immer so aussagefähig sind. Erfindungsgemäß wird daher die Gewinnung von Qualitätsinformationen optimal auf den Interleaver abgestimmt, derart, dass bei reduzierter Komplexität im selben Maße auch die Komplexität des Kanalschätzers reduziert werden kann, ohne Qualitätsverluste hinnehmen zu müssen.

Nachfolgend wird auf die bereits anhand von Fig. 4 und Fig. 5 angedeuteten Decodiererstrategien detaillierter eingegangen. Da für jede IU frühzeitig der Kanalzustand ermittelt wird, kann diese Seiteninformation im De-Disperser dazu benutzt werden, die weiteren Decodierschritte damit zu steuern. Eine speicheroptimierte Implementierung stellt sich folgendermaßen dar:

Die Verwendung von niederratigen Codes erlaubt bei einem zeitlich veränderlichen Übertragungskanal, dass nur die "guten" IU (wenig gestört) gespeichert werden müssen. IU mit geringer Signalqualität brauchen nicht gespeichert zu werden. Als Beispiel sei die Verwendung eines Rate 1/4-Codes genannt, dessen Codewörter aus 96 IUs bestehen. Bei sehr gutem Empfang reichen ca. 30% der IUs aus, um diesen Code decodieren zu können, d.h. die 25% des Codes, welche bei einem Rate 1/4-Code zur Repräsentierung der Information benötigt werden plus 5% Redundanz, damit der Decoder korrekt arbeiten kann. Wenn man die Strategie "Nur die besten IUs werden gespeichert" verfolgt, kann man den benötigten Speicher auf bis zu 30% reduzieren. Für jedes Codewort werden dementsprechend nicht 96 IUs gespeichert, sondern nur die 30% * 96 = 29 IUs für die der beste Kanalzustand geschätzt wurde. Wenn bereits 29 IUs gespeichert sind und es wird noch eine weitere empfangen, die besser als die schlechteste bisher gespeicherte ist, dann wird diese schlechte einfach durch die bessere ersetzt. Dies erfolgt durch eine geeignete Interleaver-Kontroll-Einheit im Disperser.

Eine ähnliche Strategie ist insbesondere von Interesse in Zusammenhang mit Diversity Combining oder wenn der Multiplexer verschiedene Programme enthält.

Konzept 1:

- Von dem ausgewählten Programm werden so viele IUs gespeichert, wie für die Decodierung gebraucht werden (siehe Beispiel oben).

- Der Rest wird für andere Programme verwendet, damit ein schneller Programmwechsel möglich wird (siehe Fast Access). Dadurch wird der vorhandene Speicher optimal ausgenutzt.

Konzept 2:

- Im Fall von Diversity Combining werden frühzeitig nur die guten IUs gespeichert. Hierdurch wird der benötigte Speicher verkleinert.

Eine alternative oder zusätzlich angewandte für den Energieverbrauch optimierte Strategie stellt sich folgendermaßen dar:
Wenn genügend "gute" IUs empfangen wurden, kann der Receiver abgeschaltet werden. Der Empfänger misst also fortlaufend die Qualität der empfangenen IUs. Wenn genügend IUs mit guter Signalqualität empfangen wurden, werden die restlichen nicht mehr benötigt und können durch "Erasures" ersetzt werden. Wenn z.B. das Übertragungssystem so ausgelegt ist, dass eine gewisse Reichweite (maximaler Abstand zwischen Sender und Empfänger) erlaubt ist, empfangen alle Empfänger, die sich näher am Sender befinden, die Daten mit einer höheren Qualität. Die Empfänger benötigen also nicht mehr alle IUs für eine fehlerfreie Decodierung. Wenn also einzelne IUs nicht mehr benötigt werden, können die zugehörigen Teile des Receivers immer wieder kurzzeitig abgeschaltet werden. Dadurch wird bei portablen Geräten die Betriebsdauer verlängert, da der mittlere Leistungsverbrauch verringert wird. Die Verwaltung der Daten wird durch die gewählte Interleaver-Struktur wesentlich vereinfacht.
Eine auf einen Fast-Access hin optimierte Strategie wird optimal dann bedient, wenn der Interleaver auf einen starken Late-Teil hin konfiguriert ist, also wenn die dritte Gruppe des Dispersers von Fig. 10 stark gewichtet ist.
Bei einem Faltungs-Interleaver gilt, dass die Summe der Länge der Verzögerungsleitung im Sender und im Empfänger gleich für alle Taps ist. Wenn also im Sender die Verzögerungsleitung lang gewählt wird, ist die Verzögerungsleitung im Empfänger entsprechend kurz. Eine lange Verzögerungsleitung im Sender bedeutet, dass die zugehörigen Daten später (= "late") übertragen werden. Eine kurze Verzögerungsleitung im Empfänger bedeutet aber eine kurze Verzögerung. Die zugehörigen Bits sind also nach kürzerer Verzögerungszeit am Ausgang des De-Dispersers verfügbar (= schnellerer Zugriff = "Fast Access"). Diese Konfiguration ist insbesondere vorteilhaft, wenn eine relativ niedrige Coderate für den FEC Encoder verwendet wird.
Zusammenfassend umfasst ein Sender bzw. ein Empfänger gemäß der vorliegenden Erfindung somit eine Interleaver-Vorrichtung, die die Funktionalität eines Faltungs-Interleavers in der Verschachtelungseinrichtung implementiert, welche Verschachtelungseinheiten-weise arbeitet, WObei eine Verschachtelungseinheit mehr als ein Symbol enthält. Die Anzahl der Bits pro Symbol entspricht dabei der Symbollänge des FEC-Codierers.
Die Interleaver-Struktur hat daher das Merkmal, dass ein Codewort in eine Folge von kleineren Datenpaketen, also Verschachtelungseinheiten zerlegt wird. Eine Verschachtelungseinheit umfasst mehr als ein Informationssymbol und vorzugsweise wenigstens 128 Informationssymbole. Diese Verschachtelungseinheiten werden über einen De-Multiplexer auf verschiedene Verbindungsleitungen mit unterschiedlichen Verzögerungen verteilt, wobei die Verbindungsleitungen bzw. Verzögerungsleitungen verschiedene Längen aufweisen, bzw. auf irgendeine Art und Weise, beispielsweise durch FIFO-Speicher verschiedene Verzögerungen implementieren. Der ausgangsseitige Multiplexer multiplext den Ausgang der Verbindungsleitungen nach der entsprechenden Verzögerung wieder zu einem Datenstrom, der dann einem Modulator zugeführt wird, um schließlich ein HF-Ausgangssignal zu erzeugen.
Bei dem bevorzugten Ausführungsbeispiel wird dem Disperser ein Mixer vorgeschaltet. Damit wird der auf den ersten Blick eingeführte Nachteil der Gruppierung in Verschachtelungseinheiten ausgeglichen.
Wenn der Mixer verwendet wird, so funktioniert er als der Verschachtelungseinrichtung vorgeschalteter Blockinterleaver, der die Datenbits bzw. die Datensymbole eines Codeworts einzeln, also symbolweise bzw. bitweise umsortiert.
Zur Verbesserung der Decodierer-Funktionalität wird auf Decodiererseite für jede Verschachtelungseinheit zunächst der Kanalzustand bestimmt. Hierauf wird dann die Folge der Verschachtelungseinheiten zusammen mit den Kanalzustandsinformationen über den De-Disperser in die ursprüngliche Reihenfolge gebracht. Der Ausgang des De-Interleavers wird dann zusammen mit den Kanalzustandsinformationen von dem FEC-Decodierer weiterverarbeitet. Der Disperser ist, wie es anhand von Fig. 10 erläutert worden ist, ein konfigurierbarer Disperser, der mehrere Teile hat, deren Länge in Verschachtelungseinheiten und deren zeitliche Streckung im Hinblick auf die Delays in den jeweiligen Teilen je nach Anforderung unterschiedlich gewählt werden kann. Eine spezielle Implementierung ist die Konfiguration des Dispersers in 3 Segmente, nämlich ein Early-Segment, ein Middle-Segment und ein Late-Segment. Für bestimmte Anwendungen kann auch eine Early-Late-Konfiguration oder eine Equal-Late-Konfiguration dienlich sein, wobei in der letzteren Konfiguration ein niederratiger FEC-Code und ein starker Late-Teil bevorzugt werden, um einen Fast-Access zu erlauben. Alternative Konfigurationen sind die Early/Equal-Konfiguration oder die komplementäre Disperser-Konfiguration im Falle von Transmit-Diversity. Auf Decodiererseite wird ein Decodierer-Algorithmus bevorzugt, der gute und für die Decodierung benötigte Verschachtelungseinheiten im Speicher ablegt, während schlechtere durch bessere Verschachtelungseinheiten ersetzt werden oder schlechtere Verarbeitungseinheiten nicht gespeichert werden. Die Verschachtelungseinheiten werden, wenn der Kanal besser als geplant ist, ebenfalls nicht gespeichert. Nicht verfügbare Verschachtelungseinheiten werden hierbei als "Erasures" betrachtet.

Die Funtinalität kann insbesondere zu einem verbesserten Energie-Management verwendet werden, was insbesondere für mobile Geräte von Vorteil ist, die batteriebetrieben sind, und deren Aktivitätsdauer damit vergrößert werden kann. Insbesondere dann, wenn genügend gute Verschachtelungseinheiten empfangen worden sind, wird der entsprechende Empfängerteil abgeschaltet, um Batteriestrom zu sparen.

Abhängig von den Gegebenheiten können die erfindungsgemäßen Verfahren in Hardware oder in Software implementiert werden. Die Implementierung kann auf einem digitalen Speichermedium, insbesondere einer Diskette oder CD mit elektronisch auslesbaren Steuersignalen erfolgen, die so mit einem programmierbaren Computersystem zusammenwirken können, dass ein Verfahren ausgeführt wird. Allgemein besteht die Erfindung somit auch in einem Computer-Programm-Produkt mit einem auf einem maschinenlesbaren Träger gespeicherten Programmcode zur Durchführung des Verfahrens, wenn das Computer-Programm-Produkt auf einem Rechner abläuft. In anderen Worten ausgedrückt kann die Erfindung somit als ein Computer-Programm mit einem Programmcode zur Durchführung des Verfahrens realisiert werden, wenn das Computer-Programm auf einem Computer abläuft.

**Patentansprüche**

1. Sender zum Erzeugen eines Sendesignals, mit folgenden Merkmalen:

   einem Redundanz-hinzufügenden-Codierer (22) mit einer Coderate kleiner als 1, der ausgebildet ist, um eine Folge von Codewörtern zu erzeugen, wobei aus einem Eingangsblock von Symbolen ein Codewort der Folge von Codewörtern erzeugt wird, das eine Anzahl von Forward-Error-Correction- (FEC-) Symbolen aufweist, die größer ist als eine Anzahl von Symbolen des Eingangsblocks, wobei die Codewörter der Folge von Codewörtern mit einem LDPC- (Low Density Parity Check) Code erzeugte Codewörter sind;
   einer Interleaver-Vorrichtung zum Verarbeiten der Folge von Codewörtern, wobei die Interleaver-Vorrichtung folgende Merkmale aufweist:

   einen Block-Interleaver (18) zum symbolweisen Verändern einer Reihenfolge von FEC-Symbolen jeweils in den Codewörtern der Folge von Codewörtern, so dass eine Reihenfolge der FEC-Symbole jeweils in den Codewörtern der Folge von Codewörtern geändert wird, um veränderte Codewörter zu erhalten, wobei die veränderten Codewörter jeweils eine Sequenz von Verschachtelungseinheiten (VEij) aufweisen, wobei jede Verschachtelungseinheit wenigstens zwei Forward-Error-Correction- (FEC-) Symbole aufweist; und
   eine Verschachtelungseinrichtung (10) zum Verändern der Sequenz von Verschachtelungseinheiten in den veränderten Codewörtern, um ein verschachteltes Codewort zu erhalten, das eine veränderte Sequenz von Verschachtelungseinheiten aufweist, wobei die Verschachtelungseinrichtung (10) ausgebildet ist, um eine Reihenfolge der FEC-Symbole innerhalb einer Verschachtelungseinheit nicht zu verändern, und um die Sequenz von Verschachtelungseinheiten so zu verändern, dass zeitlich betrachtet zwischen zwei Verschachtelungseinheiten des veränderten Codeworts wenigstens eine Verschachtelungseinheit eines vorhergehenden oder nachfolgenden veränderten Codeworts angeordnet ist, wobei eine Anzahl von FEC-Symbolen in einer Verschachtelungseinheit größer als 50 und kleiner als 400 ist, und wobei eine Anzahl von Verschachtelungseinheiten von einer Länge des veränderten Codeworts abhängt und jedes veränderte Codewort 50 oder mehr Verschachtelungseinheiten aufweist; und

   einem Modulator (26) zur Erzeugung des Sendesignals durch Modulieren eines von der Verschachtelungseinrichtung (10) der Interleaver-Vorrichtung ausgegebenen Datenstroms auf einen Übertragungskanal.

2. Sender nach Anspruch 1, bei der ein FEC-Symbol ein Bit ist und jede Verschachtelungseinheit wenigstens zwei Bits aufweist, oder bei der ein FEC-Symbol ein Byte ist und jede Verschachtelungseinheit wenigstens zwei Bytes aufweist.

3. Sender nach einem der vorhergehenden Ansprüche, bei der die Verschachtelungseinrichtung (10) folgende Merkmale aufweist:

eine Mehrzahl von Verbindungsleitungen (12a, 12b, 12c), wobei jede Verbindungsleitung ausgebildet ist, um eine definierte Verzögerung zu liefern, die für jede Verbindungsleitung unterschiedlich ist, oder die für eine Verbindungsleitung im wesentlichen gleich 0 ist;
einem Eingangs-Multiplexer (11), der ausgebildet ist, um nach Speisung einer Anzahl von kompletten Verschachtelungseinheiten in eine Verbindungsleitung zu einer anderen Verbindungsleitung umzuschalten, wobei die Anzahl von kompletten Verschachtelungseinheiten größer oder gleich 1 ist; und
einem Ausgangs-Multiplexer (13), der ausgebildet ist, um nach Empfang einer Anzahl von kompletten Verschachtelungseinheiten von einer Verbindungsleitung auf eine andere Verbindungsleitung umzuschalten, wobei die Anzahl größer oder gleich 1 ist.

4. Sender nach Anspruch 3, bei der die Mehrzahl von Verbindungsleitungen eine erste Gruppe (12d) von Verbindungsleitungen aufweist, in der jede außer einer ersten Verbindungsleitung ausgebildet ist, um eine definierte erste Verzögerungsmenge (E) oder ein ganzzahliges Vielfaches der definierten ersten Verzögerungsmenge zu liefern, und bei der die Mehrzahl von Verbindungsleitungen eine zweite Gruppe (12e) von Verbindungsleitungen aufweist, wobei jede Verbindungsleitung der zweiten Gruppe ausgebildet ist, um dasselbe Vielfache der definierten ersten Verzögerung sowie eine definierte zweite Verzögerung (M) die sich von der definierten ersten Verzögerung (E) unterscheidet, oder ein ganzzahliges Vielfaches der definierten zweiten Verzögerung zu liefern.

5. Sender nach Anspruch 4, bei der die Mehrzahl von Verbindungsleitungen ferner eine dritte Gruppe (12f) von Verbindungsleitungen aufweist, wobei jede Verbindungsleitung der dritten Gruppe ausgebildet ist, um dasselbe Vielfache der definierten ersten Verzögerung sowie dasselbe Vielfache der definierten zweiten Verzögerung sowie eine definierte dritte Verzögerung (L) zu haben, die sich von der definierten ersten Verzögerung oder der definierten zweiten Verzögerung unterscheidet.

6. Sender nach einem der Ansprüche 1 bis 5, bei der die Verschachtelungseinrichtung (10) ausgebildet ist, um so zu verschachteln, dass in einem ersten Zeitraum burstartig eine Anzahl von Verschachtelungseinheiten übertragen wird, und dass ein restlicher Teil der Verschachtelungseinheiten eines veränderten Codeworts in einem anschließenden längeren Zeitraum übertragen werden, wobei in dem ersten Zeitraum mehr Verschachtelungseinheiten pro Zeiteinheit übertragen werden als in dem nachfolgenden Zeitraum.

7. Sender nach einem der vorhergehenden Ansprüche, bei der der Block-Interleaver (18) konfigurierbar ist, bei der die Verschachtelungseinrichtung (10) durch einen Konfigurationsparameter konfigurierbar ist, und bei der Konfigurationsparameter der Verschachtelungseinrichtung (10) in das Sendesignal eingebracht ist, um von einem Empfänger erfasst zu werden.

8. Verfahren zum Erzeugen eines Sendesignals, mit folgenden Schritten:

Redundanz-hinzufügendes Codieren mit einer Coderate kleiner als 1, um eine Folge von Codewörtern zu erzeugen, wobei aus einem Eingangsblock von Symbolen ein Codewort der Folge von Codewörtern erzeugt wird, das eine Anzahl von Forward-Error-Correction- (FEC-) Symbolen aufweist, die größer ist als eine Anzahl von Symbolen des Eingangsblocks, wobei die Codewörter der Folge von Codewörtern mit einem LDPC- (Low Density Parity Check) Code erzeugte Codewörter sind;
Verarbeiten der Folge von Codewörtern mit folgenden Schritten:

symbolweises Verändern einer Reihenfolge von FEC-Symbolen jeweils in den Codewörtern der Folge von Codewörtern, so dass eine Reihenfolge von FEC-Symbolen jeweils in den Codewörtern der Folge von Codewörtern geändert wird, um veränderte Codewörter zu erhalten, wobei die veränderten Codewörter jeweils eine Sequenz von Verschachtelungseinheiten aufweisen, wobei jede Verschachtelungseinheit wenigstens zwei Forward-Error-Correction- (FEC-) Symbole aufweist; und
Verändern (10) der Sequenz von Verschachtelungseinheiten in den veränderten Codewörtern, um ein verschachteltes Codewort zu erhalten, das eine veränderte Sequenz von Verschachtelungseinheiten aufweist, wobei der Schritt des Veränderns (10) so durchgeführt wird, dass eine Reihenfolge der FEC-Symbole innerhalb einer Verschachtelungseinheit nicht verändert wird, und die Sequenz von Verschachtelungseinheiten so verändert wird, dass zeitlich betrachtet zwischen zwei Verschachtelungseinheiten des veränderten Codeworts wenigstens eine Verschachtelungseinheit eines vorhergehenden oder nachfolgenden veränderten Codeworts angeordnet ist,

wobei eine Anzahl von FEC-Symbolen in einer Verschachtelungseinheit größer als 50 und kleiner als 400 ist, und wobei eine Anzahl von Verschachtelungseinheiten von einer Länge des veränderten Codeworts abhängt und jedes veränderte Codewort 50 oder mehr Verschachtelungseinheiten aufweist; und

Erzeugen des Sendesignals durch Modulieren eines von dem Schritt des Veränderns (10) ausgegebenen Datenstroms auf einen Übertragungskanal.

9. Empfänger zum Empfangen eines Signals von einer Interleaver-Vorrichtung (20), das auf einem verschachtelten Codewort basiert, das eine veränderte Sequenz von Verschachtelungseiten aufweist, wobei eine Sequenz von Verschachtelungseinheiten in veränderten Codewörtern durch einen Disperser (10) der Interleaver-Vorrichtung (20) verändert worden ist, um das verschachtelte Codewort zu erhalten, wobei eine Reihenfolge von Forward-Error-Correction- (FEC-) Symbolen in einem Codewort durch einen Mixer (18) der Interleaver-Vorrichtung (20) verändert worden ist, um ein verändertes Codewort zu erhalten, wobei ferner eine Reihenfolge der FEC-Symbole innerhalb einer Verschachtelungseinheit des veränderten Codeworts durch die Interleaver-Vorrichtung (20) nicht verändert worden ist, und wobei zwischen zwei Verschachtelungseinheiten des veränderten Codeworts wenigstens eine Verschachtelungseinheit eines vorhergehenden oder nachfolgenden veränderten Codeworts angeordnet ist, wobei das Codewort ein mit einem LDPC- (Low Density Parity Check) Code erzeugtes Codewort ist, mit folgenden Merkmalen:

einem Detektor (40) zum Erfassen der Verschachtelungseinheiten aus dem Signal, um erfasste Verschachtelungseinheiten zu erhalten;

einem Seiteninformationen-Schätzer (42) zum Schätzen einer auf eine Übertragung einer gesamten Verschachtelungseinheit der erfassten Verschachtelungseinheiten bezogenen Seiteninformation für die Verschachtelungseinheit der erfassten Verschachtelungseinheiten, wobei die Seiteninformation eine Empfangsqualitätsinformation für die Verschachtelungseinheit der erfassten Verschachtelungseinheiten aufweist; und

einem Prozessor (44) zum Weiterverarbeiten der Verschachtelungseinheit der erfassten Verschachtelungseinheiten basierend auf der für die jeweilige gesamte Verschachtelungseinheit ermittelten Seiteninformation,

wobei der Prozessor (44) ausgebildet ist, um die gesamte Verschachtelungseinheit der erfassten Verschachtelungseinheiten basierend auf der Seiteninformation entweder ganz für eine Weiterverarbeitung in einem Speicher zu speichern oder ganz für die Weiterverarbeitung zu ignorieren,

wobei die Weiterverarbeitung eine De-Disperser-Funktionalität und eine De-Mixer-Funktionalität aufweist, wobei die De-Disperser-Funktionalität zu einer Funktionalität des Dispersers (10) komplementär ist, und wobei die De-Mixer-Funktionalität zu einer Funktionalität des Mixers (18) komplementär ist, und wobei die De-Disperser-Funktionalität dadurch ausgeführt wird, dass der Speicher anders ausgelesen wird als er beschrieben worden ist, wobei der Prozessor (44) ausgebildet ist,

um eine Verschachtelungseinheit dann für die Weiterverarbeitung in dem Speicher zu speichern, wenn die Seiteninformation auf eine Empfangsqualität hinweist, die höher als eine Schwelle ist (50), und

um dann, wenn die Seiteninformation auf eine Empfangsqualität hinweist, die niedriger als die Schwelle ist (50), die gesamte Verschachtelungseinheit zu verwerfen (52), indem für die gesamte Verschachtelungseinheit in dem Speicher nichts abgespeichert wird, und

um dann bei der De-Disperser-Funktionalität die gesamte verworfene Verschachtelungseinheit mit einem Erasure zu kennzeichnen, oder

wobei der Prozessor (44) ausgebildet ist,

um dann die Verschachtelungseinheit für die Weiterverarbeitung in dem Speicher zu speichern (54), wenn durch den Prozessor (44) festgestellt worden ist, dass noch nicht genug Verschachtelungseinheiten für eine Decodierung mit einer bestimmten Fehlerrate für ein Codewort gespeichert sind, und

um dann, wenn bereits genug Verschachtelungseinheiten für die Decodierung mit der bestimmten Fehlerrate für das Codewort gespeichert sind, und dann, wenn für die Verschachtelungseinheit eine Seiteninformation geschätzt worden ist, die auf eine verbesserte Empfangsqualität für die Verschachtelungseinheit hinweist als eine Empfangsqualität einer bereits gespeicherten Verschachtelungseinheit, die bereits gespeicherte Verschachtelungseinheit mit einer schlechteren Empfangsqualität in dem Speicher zu überschreiben (54), und um dann, wenn alle gespeicherten Verschachtelungseinheiten eine bessere Qualität haben als die Verschachtelungseinheit und wenn genug Verschachtelungseinheiten gespeichert sind, um eine korrekte Decodierung des Codeworts zu ermöglichen, das veränderte Codewort der De-Mixer-Funktionalität zu unterziehen (58), wobei für Verschachtelungseinheiten, die verworfen oder nicht mehr abgespeichert worden sind, Erasures eingesetzt werden.

10. Empfänger nach Anspruch 9, bei dem der Speicher ein RAM-Speicher ist, wobei bei der De-Disperser-Funktionalität burstartig ausgelesen wird, wobei in einem Burst benachbarte Speicheradressen ausgelesen werden.

11. Verfahren zum Empfangen eines Signals von einer Interleaver-Vorrichtung (20) das auf einem verschachtelten Codewort basiert, das eine veränderte Sequenz von Verschachtelungseinheiten aufweist, wobei eine Sequenz von Verschachtelungseinheiten in veränderten Codewörtern durch einen Disperser (10) der Interleaver-Vorrichtung (20) verändert worden ist, um das verschachtelte Codewort zu erhalten, wobei eine Reihenfolge von Forward-Error-Correction- (FEC-) Symbolen in einem Codewort durch einen Mixer (18) der Interleaver-Vorrichtung (20) verändert worden ist, um ein verändertes Codewort zu erhalten, wobei ferner eine Reihenfolge der FEC-Symbole innerhalb einer Verschachtelungseinheit des veränderten Codeworts durch die Interleaver-Vorrichtung (20) nicht verändert worden ist, und wobei zwischen zwei Verschachtelungseinheiten des veränderten Codeworts wenigstens eine Verschachtelungseinheit eines vorhergehenden oder nachfolgenden veränderten Codeworts angeordnet ist, wobei das Codewort ein mit einem LDPC- (Low Density Parity Check) Code erzeugtes Codewort ist, mit folgenden Schritten:

Erfassen (40) der Verschachtelungseinheiten aus dem Signal, um erfasste Verschachtelungseinheiten zu erhalten;
Schätzen (42) einer auf eine Übertragung einer gesamten Verschachtelungseinheit der erfassten Verschachtelungseinheiten bezogenen Seiteninformation für die Verschachtelungseinheit der erfassten Verschachtelungseinheiten, wobei die Seiteninformation eine Empfangsqualitätsinformation für die Verschachtelungseinheit der erfassten Verschachtelungseinheiten aufweist; und
Weiterverarbeiten (44) der Verschachtelungseinheit der erfassten Verschachtelungseinheiten basierend auf der für die jeweilige gesamte Verschachtelungseinheit ermittelten Seiteninformation, wobei die gesamte Verschachtelungseinheit der erfassten Verschachtelungseinheiten basierend auf der Seiteninformation entweder ganz für eine Weiterverarbeitung in einem Speicher gespeichert wird oder ganz für die Weiterverarbeitung ignoriert wird,
wobei das Weiterverarbeiten (44) eine De-Disperser-Funktionalität und eine De-Mixer-Funktionalitat aufweist, wobei die De-Disperser-Funktionalität zu einer Funktionalität des Dispersers (10) komplementär ist, und wobei die De-Mixer-Funktionalität zu einer Funktionalität des Mixers (18) komplementär ist, und wobei die De-Disperser-Funktionalität dadurch ausgeführt wird, dass der Speicher anders ausgelesen wird als er beschrieben worden ist,
wobei das Weiterverarbeiten (44) ausgebildet ist,

um eine Verschachtelungseinheit dann für die Weiterverarbeitung in dem Speicher zu speichern, wenn die Seiteninformation auf eine Empfangsqualität hinweist, die höher als eine Schwelle ist (50), und
um dann, wenn die Seiteninformation auf eine Empfangsqualität hinweist, die niedriger als die Schwelle ist (50), die gesamte Verschachtelungseinheit zu verwerfen (52), indem für die gesamte Verschachtelungseinheit in dem Speicher nichts abgespeichert wird, und
um dann bei der De-Disperser-Funktionalität die gesamte verworfene Verschachtelungseinheit mit einem Erasure zu kennzeichnen, oder

wobei das Weiterverarbeiten (44) ausgebildet ist,

um dann die Verschachtelungseinheit für die Weiterverarbeitung in dem Speicher zu speichern (54), wenn durch den Prozessor (44) festgestellt worden ist, dass noch nicht genug Verschachtelungseinheiten für eine Decodierung mit einer bestimmten Fehlerrate für ein Codewort gespeichert sind, und
um dann, wenn bereits genug Verschachtelungseinheiten für die Decodierung mit der bestimmten Fehlerrate für das Codewort gespeichert sind, und dann, wenn für die Verschachtelungseinheit eine Seiteninformation geschätzt worden ist, die auf eine verbesserte Empfangsqualität für die Verschachtelungseinheit hinweist als eine Empfangsqualität einer bereits gespeicherten Verschachtelungseinheit, die bereits gespeicherte Verschachtelungseinheit mit einer schlechteren Empfangsqualität in dem Speicher zu überschreiben (54), und
um dann, wenn alle gespeicherten Verschachtelungseinheiten eine bessere Qualität haben als die Verschachtelungseinheit und wenn genug Verschachtelungseinheiten gespeichert sind, um eine korrekte Decodierung des Codeworts zu ermöglichen, das veränderte Codewort der De-Mixer-Funktionalität zu unterziehen (58), wobei für Verschachtelungseinheiten, die verworfen oder nicht mehr abgespeichert worden sind, Erasures eingesetzt werden.

**12.** Digitales Speichermedium mit einem Programmcode mit elektronisch auslesbaren Steuersignalen, die so mit einem programmierbaren Computersystem zusammenwirken, dass das Verfahren gemäß Patentanspruch 8 oder Patentanspruch 11 ausgeführt wird, wenn der Programmcode auf dem programmierbaren Computersystem abläuft.

**Claims**

**1.** A transmitter for generating a transmission signal, comprising:

a redundancy-adding encoder (22) with a code rate smaller than 1, which is configured to generate a sequence of codewords, a codeword of the sequence of codewords being generated from an input block of symbols, the codeword comprising a number of forward error correction (FEC) symbols greater than a number of symbols of the input block, wherein the codewords of the sequence of codewords are codewords generated by an LDPC (low-density parity check) code;
an interleaver apparatus for processing the sequence of codewords, the interleaver apparatus comprising:

a block interleaver (18) for symbol-changing an order of FEC symbols in the respective codewords of the sequence of codewords so that an order of FEC symbols in the respective codewords of the sequence of codewords is changed so as to obtain changed codewords, the changed codewords each comprising a sequence of interleaving units ($VE_{ij}$), each interleaving unit comprising at least two forward error correction (FEC) symbols; and
an interleaving means (10) for changing the sequence of interleaving units in the changed codewords to obtain an interleaved codeword comprising a changed sequence of interleaving units, wherein the interleaving means (10) is configured not to change an order of the FEC symbols within an interleaving unit and to change the sequence of interleaving units so that at least one interleaving unit of a previous or subsequent changed codeword is temporally arranged between two interleaving units of the changed codeword, wherein a number of FEC symbols in an interleaving unit is greater than 50 and smaller than 400, and wherein a number of interleaving units depends on a length of the changed codeword and each changed codeword comprises 50 or more interleaving units; and

a modulator (26) for generating the transmission signal by modulation of a data stream output from the interleaving means (10) of the interleaver apparatus onto a transmission channel.

**2.** The transmitter according to claim 1, wherein an FEC symbol is a bit and each interleaving means comprises at least two bits, or wherein an FEC symbol is a byte and each interleaving unit comprises at least two bytes.

**3.** The transmitter according to any of the preceding claims, wherein the interleaving means (10) comprises:

a plurality of connection lines (12a, 12b, 12c), wherein each connection line is configured to provide a defined delay, which is different for each connection line, or which is substantially equal to 0 for a connection line;
an input multiplexer (11) configured to switch, after feeding a number of complete interleaving units into one connection line, to another connection line, wherein the number of complete interleaving units is equal to or greater than 1; and
an output multiplexer (13) configured to switch, after reception of a number of complete interleaving units from one connection line, to another connection line, wherein the number is equal to or greater than 1.

**4.** The transmitter according to claim 3, wherein the plurality of connection lines comprise a first group (12d) of connection lines in which each connection line except for a first one is configured to provide a defined first amount of delay (E) or an integer multiple of the defined first amount of delay, and wherein the plurality of connection lines comprise a second group (12e) of connection lines, wherein each connection line of the second group is configured to provide the same multiple of the defined first delay as well as a defined second delay (M) different from the defined first delay (E), or an integer multiple of the defined second delay.

**5.** The transmitter according to claim 4, wherein the plurality of connection lines further comprise a third group (12f) of connection lines, wherein each connection line of the third group is configured to comprise the same multiple of the defined first delay as well as the same multiple of the defined second delay as well as a defined third delay (L) different from the defined first delay or the defined second delay.

6. The transmitter according to any of claims 1 to 5, wherein the interleaving means (10) is configured to interleave so that a number of interleaving units are transmitted in a first time interval, and that a remaining part of the interleaving units of a changed codeword are transmitted in an ensuing longer time interval, wherein more interleaving units per time unit are transmitted in the first time interval than in the ensuing time interval.

7. The transmitter according to any of the preceding claims, wherein the block interleaver (18) is configurable, wherein the interleaving means (10) is configurable by a configuration parameter, and wherein th configuration parameters of the interleaving means (10) is introduced into the transmission signal so as to be detected by a receiver.

8. A method for generating a transmission signal, comprising:

redundancy-adding encoding with a code rate smaller than 1 to generate a sequence of codewords, a codeword of the sequence of codewords being generated from an input block of symbols, the codeword comprising a number of forward error correction (FEC) symbols greater than a number of symbols of the input block, wherein the codewords of the sequence of codewords are codewords generated by an LDPC (low-density parity check) code;
processing the sequence of codewords, comprising:

symbol-changing an order of FEC symbols in the respective codewords of the sequence of codewords so that an order of FEC symbols in the respective codewords of the sequence of codewords is changed so as to obtain changed codewords, the changed codewords each comprising a sequence of interleaving units, each interleaving unit comprising at least two forward error correction (FEC) symbols; and
changing (10) the sequence of interleaving units in the changed codewords to obtain an interleaved codeword comprising a changed sequence of interleaving units, wherein the step of changing (10) is performed such that an order of the FEC symbols within an interleaving unit is not changed and the sequence of interleaving units is changed so that at least one interleaving unit of a previous or subsequent changed codeword is temporally arranged between two interleaving units of the changed codeword,
wherein a number of FEC symbols in an interleaving unit is greater than 50 and smaller than 400, and wherein a number of interleaving units depends on a length of the changed codeword and each changed codeword comprises 50 or more interleaving units; and

generating the transmission signal by modulating a data stream output by the step of changing (10) onto a transmission channel.

9. A receiver for receiving a signal which is based on an interleaved codeword comprising a changed sequence of interleaving units, from an interleaver apparatus (20), a sequence of interleaving units in changed codewords having been changed by a disperser (10) of the interleaver apparatus (20) in order to obtain the interleaved codeword, wherein an order of forward error correction (FEC) symbols in a codeword has been changed by a mixer (18) of the interleaver apparatus (20) to obtain a changed codeword, wherein additionally an order of the FEC symbols within a interleaving unit of the changed codeword has not been changed by the interleaving apparatus (20), and wherein at least one interleaving unit of a previous or subsequent changed codeword is arranged between two interleaving units of the changed codeword, wherein the codeword is a codeword generated by an LDPC (low-density parity check) code, comprising:

a detector (40) for detecting the interleaving units from the signal to obtain detected interleaving units;
a side information estimator (42) for estimating side information for the interleaving unit of the detected interleaving units related to a transmission of an entire interleaving unit of the detected interleaving units, the side information comprising receive quality information for the interleaving unit of the detected interleaving units; and
a processor (44) for further processing the interleaving unit of the detected interleaving units based on the side information determined for the respective entire interleaving unit,
wherein the processor (44) is configured to either store in a memory the entire interleaving unit of the detected interleaving units on the basis of the side information completely for further processing or ignore same completely for the further processing,
wherein the further processing comprises a de-disperser functionality and a de-mixer functionality, the de-disperser functionality being complementary to a functionality of the disperser (10), and the de-mixer functionality being complementary to a functionality of the mixer (18), and wherein the de-disperser functionality is performed in that the memory is read out differently than it has been written to, wherein the processor (44) is configured to:

store (50) an interleaving unit for further processing in the memory if the side information indicates a reception quality higher than a threshold, and

discard (52), if the side information indicates a reception quality lower than the threshold (50), the entire interleaving unit by storing nothing in the memory for the entire interleaving unit, and

**characterizing, in** the de-disperser functionality, the entire discarded interleaving units with an erasure, or

wherein the processor (44) is configured to

store (54) the interleaving unit for further processing in the memory if the processor (44) has determined that not enough interleaving units for decoding at a certain error rate are stored for a codeword yet, and overwrite (54) the already stored interleaving unit of worse reception quality in the memory, if enough interleaving units for decoding at a certain error rate for the codeword are already stored and if side information indicating better reception quality for the interleaving unit than a reception quality of an already stored interleaving unit has been estimated for the interleaving means, and

to subject (58), if all the stored interleaving units comprise a better quality than the interleaving unit and if enough interleaving units are stored in order to allow correct decoding of the codeword, the changed codeword to the de-mixer functionality, wherein erasures are inserted for interleaving units which have been discarded or no longer stored.

10. The receiver according to claim 9, wherein the memory is an RAM memory, wherein reading out is performed in a burst-like manner in the de-disperser functionality, wherein neighboring memory addresses are read out in a burst.

11. A method for receiving a signal which is based on an interleaved codeword comprising a changed sequence of interleaving units, from an interleaver apparatus (20), a sequence of interleaving units in changed codewords having been changed by a disperser (10) of the interleaver apparatus (20) in order to obtain the interleaved codeword, wherein an order of forward error correction (FEC) symbols in a codeword has been changed by a mixer (18) of the interleaver apparatus (20) to obtain a changed codeword, wherein additionally an order of the FEC symbols within a interleaving unit of the changed codeword has not been changed by the interleaving apparatus (20), and wherein at least one interleaving unit of a previous or subsequent changed codeword is arranged between two interleaving units of the changed codeword, wherein the codeword is a codeword generated by an LDPC (low-density parity check) code, comprising:

detecting (40) the interleaving units from the signal to obtain detected interleaving units;

estimating (42) side information for the interleaving unit of the detected interleaving units related to a transmission of an entire interleaving unit of the detected interleaving units, the side information comprising receive quality information for the interleaving unit of the detected interleaving units; and

further processing (44) the interleaving unit of the detected interleaving units based on the side information determined for the respective entire interleaving unit, wherein the entire interleaving unit of the detected interleaving units is either stored, on the basis of the side information, in a memory completely for further processing or ignored completely for the further processing,

wherein the further processing (44) comprises a de-disperser functionality and a de-mixer functionality, the de-disperser functionality being complementary to a functionality of the disperser (10), and the de-mixer functionality being complementary to a functionality of the mixer (18), and wherein the de-disperser functionality is performed in that the memory is read out differently than it has been written to,

wherein the further processing (44) is configured to:

store (50) an interleaving unit for further processing in the memory if the side information indicates a reception quality higher than a threshold, and

discard (52), if the side information indicates a reception quality lower than the threshold (50), the entire interleaving unit by storing nothing in the memory for the entire interleaving unit, and

**characterizing, in** the de-disperser functionality, the entire discarded interleaving unit with an erasure, or

wherein the further processing (44) is configured to

store (54) the interleaving unit for further processing in the memory if it has been determined by the processor (44) that not enough interleaving units for decoding at a certain error rate are stored for a codeword yet, and overwrite (54) the already stored interleaving unit of worse reception quality in the memory, if enough interleaving units for decoding at a certain error rate for the codeword are already stored and if side information indicating better reception quality for the interleaving unit than a reception quality of an already stored interleaving unit has been estimated for the interleaving means, and

to subject (58), if all the stored interleaving units comprise a better quality than the interleaving unit and if enough interleaving units are stored in order to allow correct decoding of the codeword, the changed codeword to the de-mixer functionality, wherein erasures are inserted for interleaving units which have been discarded or no longer stored.

12. A digital storage medium having a program code with electronically readable control signals which cooperate with a programmable computer program such that the method according to claim 8 or 11 is executed, when the program code runs on a programmable computer system.

**Revendications**

1. Emetteur pour générer un signal de transmission, aux caractéristiques suivantes:

   un codeur par addition de redondance (22) avec un taux de code inférieur à 1 qui est conçu pour générer une séquence de mots de code, où est généré, à partir d'un bloc d'entrée de symboles, un mot de code de la séquence de mots de code, qui présente un nombre de symboles de Correction d'Erreur Directe (FEC) qui est supérieur à un nombre de symboles du bloc d'entrée, où les mots de code de la séquence de mots de code sont des mots de code générés par un code LDPC (Low Density Parity Check);
   un dispositif d'entrelacement destiné à traiter la séquence de mots de code, où le dispositif d'entrelacement présente les caractéristiques suivantes:

   un moyen d'entrelacement de blocs (18) destiné à modifier par symbole un ordre de symboles FEC dans chacun des mots de code de la séquence de mots de code, de sorte qu'un ordre des symboles FEC dans chacun des mots de code de la séquence de mots de code soit modifié pour obtenir des mots de code modifiés, où les mots de code modifiés présentent, chacun, une séquence d'unités d'entrelacement ($VE_{ij}$), où chaque unité d'entrelacement présente au moins deux symboles de Correction d'Erreur Directe (FEC); et
   un moyen d'entrelacement (10) destiné à modifier la séquence d'unités d'entrelacement dans les mots de code modifiés pour obtenir un mot de code entrelacé qui présente une séquence d'unités d'entrelacement modifiée, où le dispositif d'entrelacement (10) est conçu pour ne pas modifier un ordre des symboles FEC dans une unité d'entrelacement, et pour modifier la séquence d'unités d'entrelacement de sorte que, considéré dans le temps, entre deux unités d'entrelacement du mot de code modifié soit disposée au moins une unité d'entrelacement d'un mot de code modifié précédent ou suivant,
   dans lequel un nombre de symboles FEC dans une unité d'entrelacement est supérieur à 50 et inférieur à 400, et dans lequel un nombre d'unités d'entrelacement dépend de la longueur du mot de code modifié et chaque mot de code modifié présente 50 unités d'entrelacement ou plus; et

   un modulateur (26) destiné à générer le signal de transmission en modulant un flux de données émis par le moyen d'entrelacement (10) du dispositif d'entrelacement sur un canal de transmission.

2. Emetteur selon la revendication 1, dans lequel un symbole FEC est un bit et chaque unité d'entrelacement présente au moins deux bits, ou dans lequel un symbole FEC est un octet et chaque unité d'entrelacement présente au moins deux octets.

3. Emetteur selon l'une des revendications précédentes, dans lequel le dispositif d'entrelacement (10) présente les caractéristiques suivantes:

   une pluralité de lignes de connexion (12a, 12b, 12c), où chaque ligne de connexion est conçue pour fournir un retard défini qui est différent pour chaque ligne de connexion ou qui est sensiblement égal à 0 pour une ligne de connexion;
   un multiplexeur d'entrée (11) qui est conçu pour commuter, après l'alimentation d'un nombre d'unités d'entrelacement complètes vers une ligne de connexion, à une autre ligne de connexion, où le nombre d'unités d'entrelacement complètes est supérieur ou égal à 1; et
un multiplexeur de sortie (13) qui est conçu pour commuter, après réception d'un nombre d'unités d'entrelacement complètes, d'une ligne de connexion à une autre ligne de connexion, où le nombre est supérieur ou égal à 1.

4. Emetteur selon la revendication 3, dans lequel la pluralité de lignes de connexion présente un premier groupe (12d) de lignes de connexion dans lequel chacune d'elles, en-dehors d'une première ligne de connexion, est conçue pour fournir une première quantité de retard définie (E) ou un multiple entier de la première quantité de retard définie, et dans lequel la pluralité de lignes de connexion présente un deuxième groupe (12e) de lignes de connexion, où chaque ligne de connexion du deuxième groupe est conçue pour fournir le même multiple du premier retard défini ainsi qu'un deuxième retard défini (M) qui diffère du premier retard défini (E), ou un multiple entier du deuxième retard défini.

5. Emetteur selon la revendication 4, dans lequel la pluralité de lignes de connexion présente par ailleurs un troisième groupe (12f) de lignes de connexion, où chaque ligne de connexion du troisième groupe est conçue pour présenter le même multiple du premier retard défini ainsi que le même multiple du deuxième retard défini ainsi qu'un troisième retard défini (L) qui diffère du premier retard défini ou du deuxième retard défini.

6. Emetteur selon l'une des revendications 1 à 5, dans lequel le dispositif d'entrelacement (10) est conçu pour s'entrelacer de sorte que pendant un premier laps de temps soit transmises en rafales un nombre d'unités d'entrelacement, et qu'une partie restante des unités d'entrelacement d'un mot de code modifié soit transmise pendant un laps de temps ultérieur plus long, où pendant le premier laps de temps sont transmises plus d'unités d'entrelacement par unité de temps que pendant le laps de temps suivant.

7. Emetteur selon l'une des revendications précédentes, dans lequel le dispositif d'entrelacement de blocs (18) peut être configuré, dans lequel le moyen d'entrelacement (10) peut être configuré par un paramètre de configuration, et dans lequel le paramètre de configuration du moyen d'entrelacement (10) est incorporé dans le signal de transmission pour être détecté par un récepteur.

8. Procédé pour générer un signal de transmission, aux étapes suivantes consistant à:

coder par addition de redondance avec un taux de code inférieur à 1 pour générer une séquence de mots de code, où est généré, à partir d'un bloc d'entrée de symboles, un mot de code de la séquence de mots de code qui présente un nombre de symboles de Correction d'Erreur Directe (FEC) qui est supérieur à un nombre de symboles du bloc d'entrée, où les mots de code de la séquence de mots de code sont des mots de code générés par un code LDPC (Low Density Parity Check);
traiter la séquence de mots de code par les étapes suivantes consistant à:

modifier par symbole un ordre de symboles FEC dans chacun des mots de code de la séquence de mots de code, de sorte qu'un ordre des symboles FEC dans chacun des mots de code de la séquence de mots de code soit modifié pour obtenir des mots de code modifiés, où les mots de code modifiés présentent, chacun, une séquence d'unités d'entrelacement ($VE_{ij}$), où chaque unité d'entrelacement présente au moins deux symboles de Correction d'Erreur Directe (FEC); et
modifier (10) la séquence d'unités d'entrelacement dans les mots de code modifiés pour obtenir un mot de code entrelacé qui présente une séquence d'unités d'entrelacement modifiée, où l'étape consistant à modifier (10) est réalisée de sorte qu'un ordre des symboles FEC dans une unité d'entrelacement ne soit pas modifié, et que la séquence d'unités d'entrelacement soit modifiée de sorte que, considéré dans le temps, entre deux unités d'entrelacement du mot de code modifié soit disposée au moins une unité d'entrelacement d'un mot de code modifié précédent ou suivant,
dans lequel un nombre de symboles FEC dans une unité d'entrelacement est supérieur à 50 et inférieur à 400, et dans lequel un nombre d'unités d'entrelacement dépend d'une longueur du mot de code modifié et chaque mot de code modifié présente 50 unités d'entrelacement ou plus; et

générer le signal de transmission en modulant un flux de données émis par l'étape consistant à modifier (10) sur un canal de transmission.

9. Récepteur pour recevoir un signal d'un dispositif d'entrelacement (20) qui est basé sur un mot de code entrelacé qui présente une séquence d'unités d'entrelacement modifiée, où une séquence d'unités d'entrelacement dans les mots de code modifiés a été modifiée par un disperseur (10) du dispositif d'entrelacement (20) pour obtenir le mot de code entrelacé, où un ordre des symboles de Correction d'Erreur Directe (FEC) dans un mot de code a été modifié par un mélangeur (18) du dispositif d'entrelacement (20) pour obtenir un mot de code modifié, où par ailleurs un ordre des symboles FEC dans une unité d'entrelacement du mot de code modifié n'a pas été modifié par le dispositif d'entrelacement (20), et où est disposée, entre deux unités d'entrelacement du mot de code modifié, au moins une unité d'entrelacement d'un mot de code modifié précédent ou suivant, où le mot de code est un mot de code généré par un code LDPC (Low Density Parity Check), aux caractéristiques suivantes:

un détecteur (40) destiné à détecter les unités d'entrelacement à partir du signal pour obtenir les unités d'entrelacement détectées;

un estimateur d'information latérale (42) destiné à estimer une information latérale relative à une transmission d'une unité d'entrelacement complète des unités d'entrelacement détectées pour l'unité d'entrelacement des unités d'entrelacement détectées, où l'information latérale présente une information de qualité de réception pour l'unité d'entrelacement des unités d'entrelacement détectées; et

un processeur (44) destiné à traiter ultérieurement l'unité d'entrelacement des unités d'entrelacement détectées sur base de l'information latérale déterminée pour l'unité d'entrelacement complète respective, où le processeur (44) est conçu pour soit mémoriser complètement dans une mémoire pour un traitement ultérieur, soit ignorer complètement pour un traitement ultérieur l'unité d'entrelacement complète des unités d'entrelacement détectées sur base de l'information latérale,

dans lequel le traitement ultérieur présente une fonctionnalité de dé-disperseur et une fonctionnalité de dé-mélangeur, où la fonctionnalité de dé-disperseur est complémentaire à une fonctionnalité du disperseur (10), et où la fonctionnalité de dé-mélangeur est complémentaire à une fonctionnalité du mélangeur (18), et où la fonctionnalité de dé-disperseur est réalisée en ce que la mémoire est lue de manière différente de celle dont elle est écrite,

dans lequel le processeur (44) est conçu

pour mémoriser une unité d'entrelacement dans la mémoire pour le traitement ultérieur lorsque l'information latérale indique une qualité de réception qui est supérieure à un seuil (50), et

pour rejeter (52), lorsque l'information latérale indique une qualité de réception qui est inférieure au seuil (50), l'unité d'entrelacement complète en ne mémorisant rien dans la mémoire pour l'unité d'entrelacement complète, et

pour marquer alors, dans la fonctionnalité de dé-disperseur, l'unité d'entrelacement rejetée complète par un effacement, ou

dans lequel le processeur (44) est conçu

pour mémoriser (54) l'unité d'entrelacement dans la mémoire pour le traitement ultérieur lorsqu'il a été constaté par le processeur (44) qu'il n'y a pas encore été mémorisé suffisamment d'unités d'entrelacement pour un décodage avec un taux d'erreur déterminé pour un mot de code, et

pour effacer par une nouvelle écriture (54) dans la mémoire, lorsqu'il y a déjà été mémorisé suffisamment d'unités d'entrelacement pour le décodage avec le taux d'erreur déterminé pour le mot de code, et que pour l'unité d'entrelacement a été estimée l'information latérale qui indique, pour l'unité d'entrelacement, une qualité de réception améliorée par rapport à une qualité de réception d'une unité d'entrelacement déjà mémorisée, l'unité d'entrelacement avec une qualité de réception inférieure déjà mémorisée, et

pour soumettre (58), lorsque toutes les unités d'entrelacement mémorisées sont de meilleure qualité que l'unité d'entrelacement et que suffisamment d'unités d'entrelacement sont mémorisées pour permettre un décodage correct du mot de code, le mot de code modifié à la fonctionnalité de dé-mélangeur, où pour les unités d'entrelacement qui ont été rejetées ou n'ont plus été mémorisées sont utilisés des effacements.

**10.** Récepteur selon la revendication 9, dans lequel la mémoire est une mémoire RAM, où la fonctionnalité de dé-disperseur est lue en rafales, où en une rafale sont lues des adresses de mémoire adjacentes.

**11.** Procédé pour recevoir un signal d'un dispositif d'entrelacement (20) qui est basé sur un mot de code entrelacé qui présente une séquence d'unités d'entrelacement modifiée, dans lequel une séquence d'unités d'entrelacement dans les mots de code modifiés a été modifiée par un disperseur (10) du dispositif d'entrelacement (20) pour obtenir le mot de code entrelacé, dans lequel un ordre de symboles de Correction d'Erreur Directe (FEC) dans un mot de code a été modifié par un mélangeur (18) du dispositif d'entrelacement (20) pour obtenir un mot de code modifié, dans lequel par ailleurs un ordre des symboles FEC dans une unité d'entrelacement du mot de code modifié n'a pas été modifié par le dispositif d'entrelacement (20), et dans lequel est disposée, entre deux unités d'entrelacement du mot de code modifié, au moins une unité d'entrelacement d'un mot de code modifié précédent ou suivant, où le mot de code est un mot de code généré par un code LDPC (Low Density Parity Check), aux étapes suivantes consistant à:

détecter (40) les unités d'entrelacement à partir du signal, pour obtenir des unités d'entrelacement détectées;
estimer (42) une information latérale relative à une transmission d'une unité d'entrelacement complète des unités d'entrelacement détectées pour l'unité d'entrelacement des unités d'entrelacement détectées, où l'information latérale présente une information de qualité de réception pour l'unité d'entrelacement des unités d'entrelacement détectées; et

traiter ultérieurement (44) l'unité d'entrelacement des unités d'entrelacement détectées sur base de l'information latérale déterminée pour l'unité d'entrelacement complète respective, où l'unité d'entrelacement complète des unités d'entrelacement détectées est soit mémorisée complètement dans la mémoire pour un traitement ultérieur, soit complètement ignorée pour le traitement ultérieur,
dans lequel le traitement ultérieur (44) présente une fonctionnalité de dé-disperseur et une fonctionnalité de dé-mélangeur, où la fonctionnalité de dé-disperseur est complémentaire à une fonctionnalité du disperseur (10), et où la fonctionnalité de dé-mélangeur est complémentaire à une fonctionnalité du mélangeur (18), et où la fonctionnalité de dé-disperseur est réalisée en ce que la mémoire est lue de manière différente de celle dont elle est écrite,
dans lequel le traitement ultérieur (44) est conçu

pour mémoriser une unité d'entrelacement dans la mémoire pour le traitement ultérieur lorsque l'information latérale indique une qualité de réception qui est supérieure à un seuil (50), et
pour rejeter (52) l'unité d'entrelacement complète lorsque l'information latérale indique une qualité de réception qui est inférieure au seuil (50) en ne mémorisant rien dans la mémoire pour l'unité d'entrelacement complète, et
pour marquer alors, dans la fonctionnalité de dé-disperseur, l'unité d'entrelacement rejetée complète par un effacement, ou

dans lequel le traitement ultérieur (44) est conçu

pour mémoriser (54) l'unité d'entrelacement dans la mémoire pour le traitement ultérieur lorsqu'il a été constaté par le processeur (44) qu'il n'a pas encore été mémorisé suffisamment d'unités d'entrelacement pour un décodage avec un taux d'erreur déterminé pour un mot de code, et
pour effacer par une nouvelle écriture (54) dans la mémoire, lorsqu'il a déjà été mémorisé suffisamment d'unités d'entrelacement pour le décodage avec le taux d'erreur déterminé pour le mot de code, et que pour l'unité d'entrelacement a été estimée une information latérale qui indique, pour l'unité d'entrelacement, une qualité de réception améliorée par rapport à une qualité de réception d'une unité d'entrelacement déjà mémorisée, l'unité d'entrelacement avec une qualité de réception inférieure déjà mémorisée, et
pour soumettre (58), lorsque toutes les unités d'entrelacement mémorisées sont de meilleure qualité que l'unité d'entrelacement et que suffisamment d'unités d'entrelacement sont mémorisées pour permettre un décodage correct du mot de code, le mot de code modifié à la fonctionnalité de dé-mélangeur, où pour les unités d'entrelacement qui ont été rejetées ou n'ont plus été mémorisées sont utilisés des effacements.

12. Support de mémoire numérique avec un code de programme avec des signaux de commande lisibles électroniquement qui coopèrent avec un système informatique programmable de sorte que soit réalisé le procédé selon la revendication 8 ou la revendication 11 lorsque le code de programme est exécuté sur le système informatique programmable.

# FIG 1

VE$_{ij}$ : i $\triangleq$ Sequenznummer
des Codeworts in
der Codewortsequenz

J $\triangleq$ Sequenznummer
des VE in dem Codewort i

D : Verzögerung um eine
Verzögerungseinheit

- zwischen VE$_{21}$ und VE$_{22}$ liegen VE$_{11}$, VE$_{13}$ des vorhergehenden Codeworts CW$_1$
- zwischen VE$_{21}$ und VE$_{22}$ liegt Ve$_{24}$
- zwischen VE$_{31}$ und VE$_{33}$ liegt nicht Ve$_{32}$

## FIG 2

## FIG 3

EP 2 027 656 B1

## FIG 4

Empfangssignal mit
verschachtelten Verschachtelungseinheiten

Seiteninfoschätzer

42

VE-
Detektor —40

Prozessor zum
Weiterverarbeiten
mit der Seiteninfo —44

38

Dekodierer

Audio/Video/
· · ·

Folge von Verschachtelungseinheiten
mit kompletten
Erasure - Verschachtelungseinheiten

## FIG 5

50— Qualität besser als
Schwelle

nein

VE verwerfen —50

ja

54— VE speichern oder
gesp. VE überschreiben

56— genug VE gespeichert?

noch Speicher frei —60

ja

58— mit der Dekodierung
beginnen

anderes Programm
speichern —62

FIG 6

FIG 7

## FIG 8

| 191 Spalten | 64 Spalten |
|---|---|
| 0                    190 | 0                    63 |
| **Anwendungsdatentabelle**<br>**(Schicht-3-Datagramme)** | **RS-Datentabelle**<br>**(RS-Daten)** |

0

Anz_von_Zeilen-1

## FIG 9

Spalte# 0 ... 190

Zeile# 0 ... Anz_von_Zeilen-1

1. Datagramm

1. Datagramm fortges. | 2. Datagramm

2. Datagramm fortges. | 3. Datagramm

• • •

letztes Datagramm

Auffüllbytes fortges. | Auffüllbytes

• • •

letzte Auffüllbytes

FIG 10

$E = tapDiffMult * earlyTapDiff * IU\_Len$

$M = tapDiffMult * middleTapDiff * IU\_Len$

$L = tapDiffMult * lateTapDiff * IU\_Len$

EP 2 027 656 B1

# FIG 11

### Gleichmäßiges Interleaver-Profil

Prozent übertragener Bits

Prozent Gesamtinterleaverlänge

# FIG 12

### Gleichmäßig/Spät-Interleaver-Profil

Prozent übertragener Bits

Prozent Gesamtinterleaverlänge

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5968200 A